# EUROPEAN PATENT APPLICATION

(11) **EP 3 220 246 A1**
(43) Date of publication of application: **20.09.2017**
(21) Application number: 17161428.2
(22) Date of filing: 16.03.2017
(51) Int. Cl.: G06F 3/041, G06F 3/044

(54) **TOUCH INPUT DEVICE**

(30) Priority: 16.03.2016 KR 20160031582
(71) Applicant: HiDeep Inc., Gyeonggi-do 463-400 (KR)
(72) Inventor: Kim, Bonkee, 13493 Gyeonggi-do (KR); CHO, Young ho, 13493 Gyeonggi-do (KR)
(74) Representative: Patronus IP Patent- und Rechtsanwälte

(57) **Abstract**

A touch input device capable of detecting a touch pressure is provided that includes: a reference potential layer (600); a pressure sensor (450, 460) spaced apart from the reference potential layer; and an intermediate device (700) having at least one through-hole (740) formed therein. Air between the reference potential layer and the pressure sensor flows through the intermediate device via the through-hole. A capacitance detected by the pressure sensor is changed according to a change of a distance (d) between the reference potential layer and the pressure sensor.

## Description

### BACKGROUND

### Field

The present disclosure relates to a touch input device, and more particularly to a touch input device which makes it easier to detect a touch pressure.

### Description of the Related Art

Various kinds of input devices are being used to operate a computing system. For example, the input device includes a button, key, joystick and touch screen. Since the touch screen is easy and simple to operate, the touch screen is increasingly being used in operation of the computing system.

The touch screen may constitute a touch surface of a touch input device including a touch sensor panel which may be a transparent panel including a touch-sensitive surface. The touch sensor panel is attached to the front side of a display screen, and then the touch-sensitive surface may cover the visible side of the display screen. The touch screen allows a user to operate the computing system by simply touching the touch screen by a finger, etc. Generally, the computing system recognizes the touch and a position of the touch on the touch screen and analyzes the touch, and thus, performs the operations in accordance with the analysis.

A demand for a touch input device capable of detecting not only the touch position but also the magnitude of a touch pressure is increasing. In addition to this, efforts are now being constantly made to improve the convenience for users at the time of using the magnitude of the pressure as an input.

### SUMMARY

One embodiment is a touch input device which is capable of detecting a touch pressure and includes: a reference potential layer; a pressure sensor spaced apart from the reference potential layer; and an intermediate device having at least one through-hole formed therein. Air between the reference potential layer and the pressure sensor flows through the intermediate device via the through-hole. A capacitance detected by the pressure sensor is changed according to a change of a distance between the reference potential layer and the pressure sensor.

Another embodiment is a touch input device capable of detecting a touch pressure and includes: an LCD panel which includes a liquid crystal layer, and a first substrate layer and a second substrate layer, both of which have the liquid crystal layer placed therebetween, wherein at least a portion of a touch sensor which detects the touch in a capacitive manner is located between the first substrate layer and the second substrate layer; and a backlight unit which is located under the LCD panel and includes an optical film, a light source, a reflective sheet, and a support member. The backlight unit further includes a pressure sensor which is located between the reflective sheet and the support member and is attached on the support member. A drive signal is applied to the touch sensor and a touch position is detected by a sensing signal output from the touch sensor. A magnitude of the touch pressure is detected on the basis of a capacitance detected by the pressure sensor. At least one through-hole is formed in the support member.

Further another embodiment is a touch input device capable of detecting a touch pressure and includes: an OLED panel which includes an organic layer, and a first substrate layer and a second substrate layer, both of which have the organic layer placed therebetween; a pressure sensor which is disposed on the first substrate layer; a reference potential layer which is disposed apart from the pressure sensor; and an intermediate device having at least one through-hole formed therein. Air between the reference potential layer and the pressure sensor flows through the intermediate device via the through-hole. A capacitance detected by the pressure sensor is changed according to a change of a distance between the reference potential layer and the pressure sensor.

Yet another embodiment is a touch input device capable of detecting a touch pressure and includes: an LCD panel which includes a liquid crystal layer, and a first substrate layer and a second substrate layer, both of which have the liquid crystal layer placed therebetween, wherein at least a portion of a touch sensor which detects the touch in a capacitive manner is located between the first substrate layer and the second substrate layer; a backlight unit which is located under the LCD panel; and an intermediate device which is located under the backlight unit and has at least one through-hole formed therein. A drive signal is applied to the touch sensor and a touch position is detected by a sensing signal output from the touch sensor.

### BRIEF DESCRIPTION OF THE DRAWINGS

Figs. 1a and 1b are schematic views of a configuration of a capacitance type touch sensor panel and the operation thereof in accordance with an embodiment of the present invention;
Figs. 2a to 2e are conceptual views showing a relative position of the touch sensor panel with respect to a display panel in a touch input device according to the embodiment;
Fig. 3a is a cross sectional view showing a first example of the touch input device configured to detect a touch position and a touch pressure in accordance with the embodiment;
Fig. 3b is a cross sectional view showing a second example of the touch input device configured to detect a touch position and a touch pressure in accordance with the embodiment;
Fig. 3c shows an optical layer of a backlight unit in the touch input device according to the embodiment;
Fig. 3d is a cross sectional view showing a third example of the touch input device configured to detect a touch position and a touch pressure in accordance with the embodiment;
Fig. 3e is a cross sectional view showing a modified example of the third example of the touch input device configured to detect a touch position and a touch pressure in accordance with the embodiment;
Figs. 4a and 4b show a relative distance between a reference potential layer and a pressure sensor of a first example which are included in the touch input device, and show a pressure is applied to the touch input device;
Figs. 4c and 4d show a relative distance between a reference potential layer and a pressure sensor of a second example which are included in the touch input device, and show that a pressure is applied to the touch input device;
Fig. 4e shows the arrangement of pressure sensors of a third example which is included in the touch input device;
Figs. 5a to 5e show patterns according to first to fifth examples of an electrode constituting the pressure sensor according to the embodiment;
Fig. 6a is a cross sectional view of an exemplary electrode sheet which includes a pressure electrode and is to be attached to the touch input device according to the embodiment;
Fig. 6b is a cross sectional view showing a portion of the touch input device to which the electrode sheet has been attached according to a first method;
Fig. 6c is a plan view of the electrode sheet to be attached to the touch input device in accordance with the first method;
Fig. 6d is a cross sectional view showing a portion of the touch input device to which the electrode sheet has been attached according to a second method;
Figs. 7a to 7e show the first to the fifth example showing an arrangement relationship between the reference potential layer and an intermediate device in the touch input device according to the embodiment of the present invention;
Figs. 8a to 8c show the first to the third examples showing the intermediate device having a through-hole formed therein in the touch input device according to the embodiment of the present invention;
Figs. 9a to 9c show a structure in which the electrode for the pressure detection and touch position detection is located within the display panel;
Figs. 10a and 10b show a structure in which the internal configuration of the display panel is used as the electrode for the pressure detection; and
Figs. 11 a to 11 c show a structure of the touch input device including an OLED display panel.

### DETAILED DESCRIPTION

The following detailed description of the present invention shows a specified embodiment of the present invention and will be provided with reference to the accompanying drawings. The embodiment will be described in enough detail that those skilled in the art are able to embody the present invention. It should be understood that various embodiments of the present invention are different from each other and need not be mutually exclusive. For example, a specific shape, structure and properties, which are described in this disclosure, may be implemented in other embodiments without departing from the spirit and scope of the present invention with respect to one embodiment. Also, it should be noted that positions or placements of individual components within each disclosed embodiment may be changed without departing from the spirit and scope of the present invention. Similar reference numerals in the drawings designate the same or similar functions in many aspects.

Hereinafter, a touch input device according to an embodiment of the present invention will be described with reference to the accompanying drawings. Hereinafter, a capacitance type touch sensor panel 100 and pressure sensors 450 and 460 will be described. In addition, it is possible to apply a method for detecting a touch position and/or a touch pressure in another manner in accordance with the embodiment.

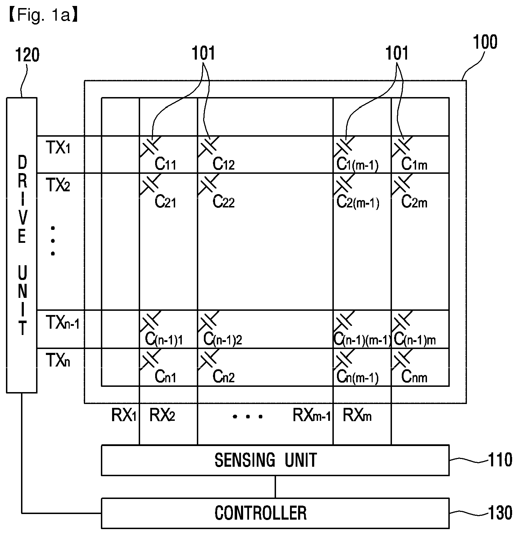

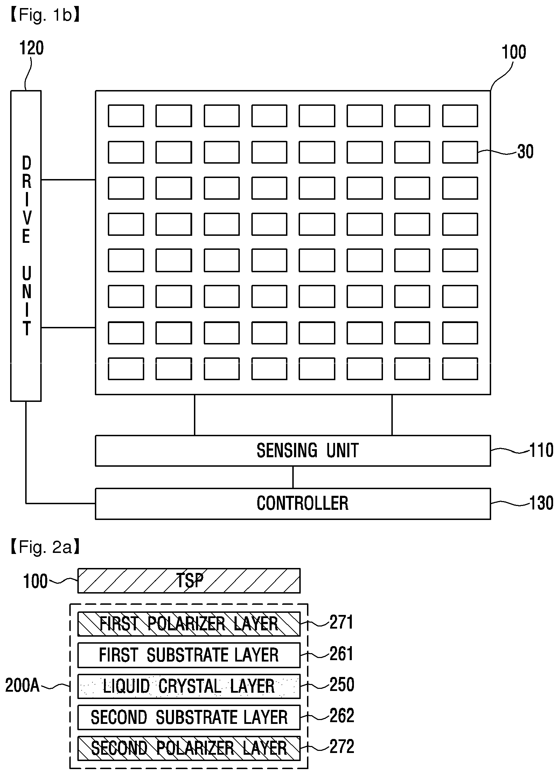

Fig. 1 a is a schematic view of a configuration of the capacitance type touch sensor panel 100 and the operation thereof in accordance with the embodiment. Referring to Fig. 1a, a touch sensor panel 100 according to the embodiment may include a plurality of drive electrodes TX1 to TXn and a plurality of receiving electrodes RX1 to RXm. The touch sensor panel 100 may include a drive unit 120 which applies a drive signal to the plurality of drive electrodes TX1 to TXn for the purpose of the operation of the touch sensor panel 100, and a sensing unit 110 which detects whether the touch has occurred or not and/or the touch position by receiving a sensing signal including information on the capacitance change amount changing according to the touch on the touch surface of the touch sensor panel 100.

As shown in Fig. 1 a, the touch sensor panel 100 may include the plurality of drive electrodes TX1 to TXn and the plurality of receiving electrodes RX1 to RXm. While Fig. 1 a shows that the plurality of drive electrodes TX1 to TXn and the plurality of receiving electrodes RX1 to RXm of the touch sensor panel 100 form an orthogonal array, the present invention is not limited to this. The plurality of drive electrodes TX1 to TXn and the plurality of receiving electrodes RX1 to RXm has an array of arbitrary dimension, for example, a diagonal array, a concentric array, a 3-dimensional random array, etc., and an array obtained by the application of them. Here, "n" and "m" are positive integers and may be the same as each other or may have different values. The magnitude of the value may be changed depending on the embodiment.

As shown in Fig. 1 a, the plurality of drive electrodes TX1 to TXn and the plurality of receiving electrodes RX1 to RXm may be arranged to cross each other. The drive electrode TX may include the plurality of drive electrodes TX1 to TXn extending in a first axial direction. The receiving electrode RX may include the plurality of receiving electrodes RX1 to RXm extending in a second axial direction crossing the first axial direction.

In the touch sensor panel 100 according to the embodiment, the plurality of drive electrodes TX1 to TXn and the plurality of receiving electrodes RX1 to RXm may be formed in the same layer. For example, the plurality of drive electrodes TX1 to TXn and the plurality of receiving electrodes RX1 to RXm may be formed on the same side of an insulation layer (not shown). Also, the plurality of drive electrodes TX1 to TXn and the plurality of receiving electrodes RX1 to RXm may be formed in different layers. For example, the plurality of drive electrodes TX1 to TXn and the plurality of receiving electrodes RX1 to RXm may be formed on both sides of one insulation layer (not shown) respectively, or the plurality of drive electrodes TX1 to TXn may be formed on a side of a first insulation layer (not shown) and the plurality of receiving electrodes RX1 to RXm may be formed on a side of a second insulation layer (not shown) different from the first insulation layer.

The plurality of drive electrodes TX1 to TXn and the plurality of receiving electrodes RX1 to RXm may be made of a transparent conductive material (for example, indium tin oxide (ITO) or antimony tin oxide (ATO) which is made of tin oxide (SnO₂), and indium oxide (In₂O₃), etc.), or the like. However, this is only an example. The drive electrode TX and the receiving electrode RX may be also made of another transparent conductive material or an opaque conductive material. For instance, the drive electrode TX and the receiving electrode RX may include at least any one of silver ink, copper, and carbon nanotube (CNT). Also, the drive electrode TX and the receiving electrode RX may be made of metal mesh or nano silver.

The drive unit 120 according to the embodiment may apply a drive signal to the drive electrodes TX1 to TXn. In the embodiment, one drive signal may be sequentially applied at a time to the first drive electrode TX1 to the n-th drive electrode TXn. The drive signal may be applied again repeatedly. This is only an example. The drive signal may be applied to the plurality of drive electrodes at the same time in accordance with the embodiment.

Through the receiving electrodes RX1 to RXm, the sensing unit 110 receives the sensing signal including information on a capacitance (Cm) 101 generated between the receiving electrodes RX1 to RXm and the drive electrodes TX1 to TXn to which the drive signal has been applied, thereby detecting whether or not the touch has occurred and the touch position. For example, the sensing signal may be a signal coupled by the capacitance (Cm) 101 generated between the receiving electrode RX and the drive electrode TX to which the drive signal has been applied. As such, the process of sensing the drive signal applied from the first drive electrode TX1 to the n-th drive electrode TXn through the receiving electrodes RX1 to RXm can be referred to as a process of scanning the touch sensor panel 100.

For example, the sensing unit 110 may include a receiver (not shown) which is connected to each of the receiving electrodes RX1 to RXm through a switch. The switch becomes the on-state in a time interval during which the signal of the corresponding receiving electrode RX is sensed, thereby allowing the receiver to sense the sensing signal from the receiving electrode RX. The receiver may include an amplifier (not shown) and a feedback capacitor coupled between the negative (-) input terminal of the amplifier and the output terminal of the amplifier, i.e., coupled to a feedback path. Here, the positive (+) input terminal of the amplifier may be connected to the ground or to a reference voltage. Also, the receiver may further include a reset switch which is connected in parallel with the feedback capacitor. The reset switch may reset the conversion from current to voltage that is performed by the receiver. The negative input terminal of the amplifier is connected to the corresponding receiving electrode RX and receives and integrates a current signal including information on the capacitance (CM) 101, and then converts the integrated current signal into voltage. The sensing unit 110 may further include an analog-digital converter (ADC) (not shown) which converts the integrated data by the receiver into digital data. Later, the digital data may be input to a processor (not shown) and processed to obtain information on the touch on the touch sensor panel 100. The sensing unit 110 may include the ADC and processor as well as the receiver.

A controller 130 may perform a function of controlling the operations of the drive unit 120 and the sensing unit 110. For example, the controller 130 generates and transmits a drive control signal to the drive unit 120, so that the drive signal can be applied to a predetermined drive electrode TX1 at a predetermined time. Also, the controller 130 generates and transmits a sense control signal to the sensing unit 110, so that the sensing unit 110 may receive the sensing signal from the predetermined receiving electrode RX at a predetermined time and perform a predetermined function.

In Fig. 1 a, the drive unit 120 and the sensing unit 110 may constitute a touch detection device (not shown) capable of detecting whether or not the touch has occurred on the touch sensor panel 100 according to the embodiment and/or the touch position. The touch detection device according to the embodiment may further include the controller 130. The touch detection device according to the embodiment may be integrated and implemented on a touch sensing integrated circuit (IC) (not shown) in a touch input device 1000 including the touch sensor panel 100. The drive electrode TX and the receiving electrode RX included in the touch sensor panel 100 may be connected to the drive unit 120 and the sensing unit 110 included in the touch sensing IC through, for example, a conductive trace and/or a conductive pattern printed on a circuit board, or the like. The touch sensing IC may be placed on a circuit board on which the conductive pattern has been printed. According to the embodiment, the touch sensing IC may be mounted on a main board for operation of the touch input device 1000.

As described above, a capacitance (C) with a predetermined value is generated at each crossing of the drive electrode TX and the receiving electrode RX. When an object such as finger approaches close to the touch sensor panel 100, the value of the capacitance may be changed. In Fig. 1 a, the capacitance may represent a mutual capacitance (Cm). The sensing unit 110 senses such electrical characteristics, thereby being able to sense whether the touch has occurred on the touch sensor panel 100 or not and the touch position. For example, the sensing unit 110 is able to sense whether the touch has occurred on the surface of the touch sensor panel 100 comprised of a two-dimensional plane consisting of a first axis and a second axis and/or the touch position. More specifically, when the touch occurs on the touch sensor panel 100, the drive electrode TX to which the drive signal has been applied is detected, so that the position of the second axial direction of the touch can be detected. Likewise, when the touch occurs on the touch sensor panel 100, a capacitance change is detected from the reception signal received through the receiving electrode RX, so that the position of the first axial direction of the touch can be detected.

In the foregoing, the operation method of the touch sensor panel 100 which senses the touch position has been described on the basis of the mutual capacitance change amount between the drive electrode TX and the receiving electrode RX. However, there is no limitation to this. That is, as shown in Fig. 1 b, it is possible to sense the touch position on the basis of the change amount of a self-capacitance.

Fig. 1 b is a schematic view for describing another capacitance type touch sensor panel 100 included in a touch input device according to another embodiment of the present invention and the operation of the touch sensor panel 100. The touch sensor panel 100 shown in Fig. 1 b includes a plurality of touch electrodes 30. As shown in Fig. 1 b, the plurality of the touch electrodes 30 may be arranged at a regular interval in the form of a grid. However, there is no limitation to this.

The drive control signal generated by the controller 130 is transmitted to the drive unit 120. On the basis of the drive control signal, the drive unit 120 applies the drive signal to the predetermined touch electrode 30 at a predetermined time. Also, the sense control signal generated by the controller 130 is transmitted to the sensing unit 110. On the basis of the sense control signal, the sensing unit 110 receives the sensing signal from the predetermined touch electrode 30 at a predetermined time. Here, the sensing signal may be a signal for the change amount of a self-capacitance formed on the touch electrode 30.

Here, by the sensing signal sensed by the sensing unit 110, whether or not the touch has occurred on the touch sensor panel 100 and/or the touch position are detected. For example, it is possible to sense whether the touch has occurred or not on the surface of the touch sensor panel 100 and/or the touch position because the coordinates of the touch electrode 30 have been known in advance. In the foregoing, for convenience, it has been described that the drive unit 120 and the sensing unit 110 operate individually as a separate block. However, it is possible that one drive sensing unit applies the drive signal to the touch electrode 30 and receives the sensing signal from the touch electrode 30.

The mutual capacitance type touch sensor panel as the touch sensor panel 100 has been described in detail in the foregoing. However, in the touch input device 1000 according to the embodiment, the touch sensor panel 100 for detecting whether or not the touch has occurred and the touch position may be implemented by using not only the above-described method but also any touch sensing method like a self-capacitance type method, a surface capacitance type method, a projected capacitance type method, a resistance film method, a surface acoustic wave (SAW) method, an infrared method, an optical imaging method, a dispersive signal technology, and an acoustic pulse recognition method, etc.

Hereinafter, a configuration corresponding to the drive electrode TX and the receiving electrode RX for detecting whether or not the touch has occurred and/or the touch position may be referred to as a touch sensor 100.

In the touch input device 1000 according to the embodiment of the present invention, the touch sensor panel 100 for detecting the touch position may be positioned outside or inside a display panel 200A. The display panel 200A of the touch input device 1000 according to the embodiment may be a display panel included in a liquid crystal display (LCD), a plasma display panel (PDP), an organic light emitting diode (OLED), etc. Accordingly, a user may perform the input operation by touching the touch surface while visually identifying an image displayed on the display panel. Here, the display panel 200A may include a control circuit which receives an input from an application processor (AP) or a central processing unit (CPU) on a main board for the operation of the touch input device 1000 and displays the contents that the user wants on the display panel. Here, the control circuit for the operation of the display panel 200A may include a display panel control IC, a graphic controller IC, and other circuits required to operate the display panel 200A.

Figs. 2a to 2e are conceptual views showing a relative position of the touch sensor panel 100 with respect to the display panel 200A in the touch input device according to the embodiment. First, referring to Figs. 2a to 2c, a relative position of the touch sensor panel 100 with respect to the display panel 200A using an LCD panel will be described.

As shown in Figs. 2a to 2c, the LCD panel may include a liquid crystal layer 250 including a liquid crystal cell, a first substrate layer 261 and a second substrate layer 262 which are disposed on both sides of the liquid crystal layer 250 and include electrodes, a first polarizer layer 271 formed on a side of the first substrate layer 261 in a direction facing the liquid crystal layer 250, and a second polarizer layer 272 formed on a side of the second substrate layer 262 in the direction facing the liquid crystal layer 250. Here, the first substrate layer 261 may be a color filter glass, and the second substrate layer 262 may be a TFT glass. Also, according to the embodiment, at least one of the first substrate layer 261 and the second substrate layer 262 may be made of a material such as plastic.

It is clear to those skilled in the art that the LCD panel may further include other configurations for the purpose of performing the displaying function and may be transformed.

Fig. 2a shows that the touch sensor panel 100 of the touch input device 1000 is disposed outside the display panel 200A. The touch surface of the touch input device 1000 may be the surface of the touch sensor panel 100. In Fig. 2a, the top surface of the touch sensor panel 100 is able to function as the touch surface. Also, according to the embodiment, the touch surface of the touch input device 1000 may be the outer surface of the display panel 200A. In Fig. 2a, the bottom surface of the second polarizer layer 272 of the display panel 200A is able to function as the touch surface. Here, in order to protect the display panel 200A, the bottom surface of the display panel 200A may be covered with a cover layer (not shown).

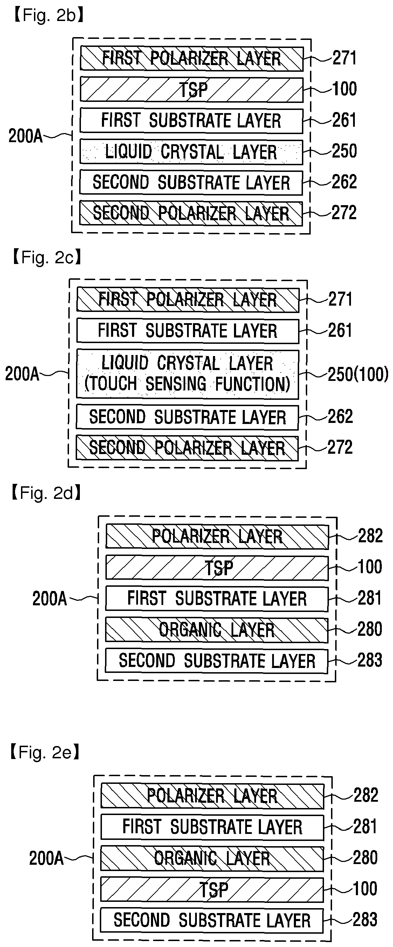

Figs. 2b and 2c show that the touch sensor panel 100 of the touch input device 1000 is disposed within the display panel 200A. Here, in Fig. 2b, the touch sensor panel 100 for detecting the touch position is disposed between the first substrate layer 261 and the first polarizer layer 271. Here, the touch surface of the touch input device 1000 is the outer surface of the display panel 200A. The top surface or bottom surface of the display panel 200A in Fig. 2b may be the touch surface. Fig. 2c shows that the touch sensor panel 100 for detecting the touch position is included in the liquid crystal layer 250. Here, the touch surface of the touch input device 1000 is the outer surface of the display panel 200A. The top surface or bottom surface of the display panel 200A in Fig. 2c may be the touch surface. In Figs. 2b and 2c, the top surface or bottom surface of the display panel 200A, which can be the touch surface, may be covered with a cover layer (not shown).

Next, a relative position of the touch sensor panel 100 with respect to the display panel 200A using an OLED panel will be described with reference to Figs. 2d and 2e. In Fig. 2d, the touch sensor panel 100 is located between a polarizer layer 282 and a first substrate layer 281. In Fig. 2e, the touch sensor panel 100 is located between an organic layer 280 and a second substrate layer 283. As a modified example of Fig. 2e, the touch sensor panel 100 may be located between the first substrate layer 281 and the organic layer 280.

Here, the first substrate layer 281 may be comprised of an encapsulation glass, and the second substrate layer 283 may be comprised of a TFT glass. Also, according to the embodiment, at least one of the first substrate layer 281 and the second substrate layer 282 may be made of a material such as plastic. Since the touch sensing has been described above, only the other configurations thereof will be briefly described.

The organic light-emitting diode (OLED) panel is a self-light emitting display panel which uses a principle in which current flows through a fluorescent or phosphorescent organic thin film and then electrons and electron holes are combined in the organic layer, so that light is generated. The organic matter constituting the light emitting layer determines the color of the light.

Specifically, the OLED uses a principle in which when electricity flows and an organic matter is applied on glass or plastic, the organic matter emits light. That is, the principle is that electron holes and electrons are injected into the anode and cathode of the organic matter respectively and are recombined in the light emitting layer, so that a high energy exciton is generated and the exciton releases the energy while falling down to a low energy state and then light with a particular wavelength is generated. Here, the color of the light is changed according to the organic matter of the light emitting layer.

The OLED includes a line-driven passive-matrix organic light-emitting diode (PM-OLED) and an individual driven active-matrix organic light-emitting diode (AM-OLED) in accordance with the operating characteristics of a pixel constituting a pixel matrix. None of them require a backlight. Therefore, the OLED enables a very thin display module to be implemented, has a constant contrast ratio according to an angle and obtains a good color reproductivity depending on a temperature. Also, it is very economical in that non-driven pixel does not consume power.

In terms of operation, the PM-OLED emits light only during a scanning time at a high current, and the AM-OLED maintains a light emitting state only during a frame time at a low current. Therefore, the AM-OLED has a resolution higher than that of the PM-OLED and is advantageous for driving a large area display panel and consumes low power. Also, a thin film transistor (TFT) is embedded in the AM-OLED, and thus, each component can be individually controlled, so that it is easy to implement a delicate screen.

As shown in Figs. 2d and 2e, basically, the OLED (particularly, AM-OLED) panel includes the polarizer layer 282, the first substrate layer 281, the organic layer 280, and the second substrate layer 283. Here, the first substrate layer 281 may be an encapsulation glass and the second substrate layer 283 may be a TFT glass. However, they are not limited to this.

Also, the organic layer 280 may include a hole injection layer (HIL), a hole transport layer (HTL), an electron injection layer (EIL), an electron transport layer (ETL), and an light-emitting layer (EML). Briefly describing each of the layers, HIL injects electron holes and uses a material such as Copper Phthalocyanine (CuPc), etc. HTL functions to move the injected electron holes and mainly uses a material having a good hole mobility. Arylamine, TPD, and the like may be used as the HTL. The EIL and ETL inject and transport electrons. The injected electrons and electron holes are combined in the EML and emit light. The EML represents the color of the emitted light and is composed of a host determining the lifespan of the organic matter and an impurity (dopant) determining the color sense and efficiency. This just describes the basic structure of the organic layer 280 include in the OLED panel. The present invention is not limited to the layer structure or material, etc., of the organic layer 280.

The organic layer 280 is inserted between the anode (not shown) and a cathode (not shown). When the TFT becomes an on-state, a driving current is applied to the anode and the electron holes are injected, and the electrons are injected to the cathode. Then, the electron holes and electrons move to the organic layer 280 and emit the light.

Also, according to the embodiment, at least a portion of the touch sensor may be configured to be positioned within the display panel 200A, and at least a portion of the remaining touch sensor may be configured to be positioned outside the display panel 200A. For example, any one of the drive electrode TX and the receiving electrode RX which constitute the touch sensor panel 100 may be configured to be positioned outside the display panel 200A, the remaining electrode may be configured to be positioned within the display panel 200A. When the touch sensor is disposed within the display panel 200A, an electrode for operating the touch sensor may be further disposed. However, various configurations and/or the electrode which are located within the display panel 200A may be used as the touch sensor for touch sensing.

According to the embodiment, at least a portion of the touch sensor 100 may be arranged between the first substrate layer 261 the second substrate layer 262 and between the first substrate layer 281 and the second substrate layer 283 which are included in the display panel 200A. Here, the remaining portion of the touch sensor 100 may be arranged in such a manner as not to be arranged between the first substrate layer 261 and the second substrate layer 262 and between the first substrate layer 281 and the second substrate layer 283. Various layers including a data line, a gate line, a TFT, a common electrode, and a pixel electrode, etc., may be formed on the second substrate layer 262. These electrical components may operate in such a manner as to generate a controlled electric field and to orient liquid crystals located in the liquid crystal layer 250. Any one of the data line, gate line, common electrode, and pixel electrode may be formed in the second substrate layer 262 and used as the touch sensor. Regarding the OLED panel, at least one of the gate line, data line, a first power line ELVDD, and a second power line ELVSS may be formed to be used as the touch sensor.

Up to now, the touch position detection by the touch sensor panel 100 according to the embodiment of the present invention has been described. Additionally, through use of the touch sensor panel 100 according to the embodiment of the present invention, it is possible to detect the magnitude of the touch pressure as well as whether the touch has occurred or not and/or where the touch has occurred. Also, the touch input device to which the pressure detection module according to the embodiment of the present invention is applied may not include the touch sensor panel 100. Also, a pressure sensor for detecting the touch pressure is included separately from the touch sensor panel 100, so that it is possible to detect the magnitude of the touch pressure. Hereafter, the pressure sensor and the touch input device including the same will be described in detail.

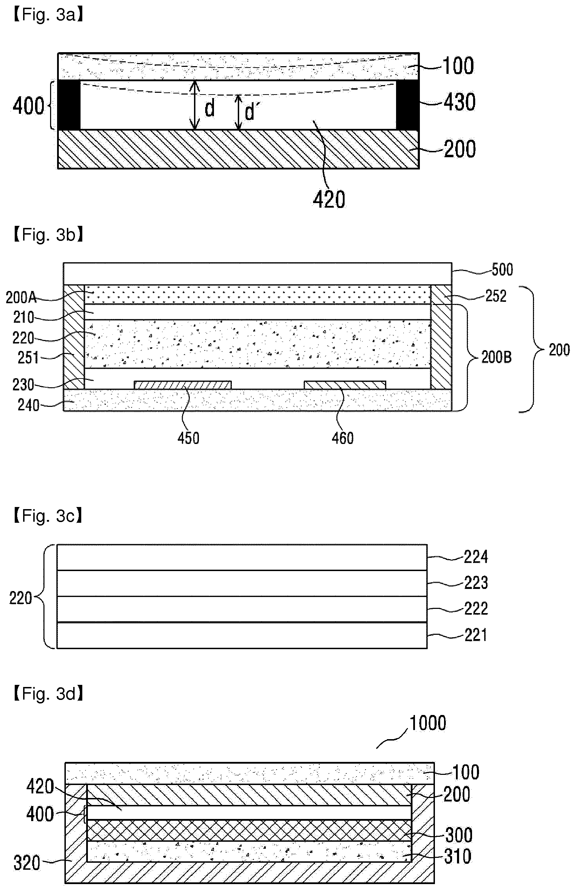

Fig. 3a is a cross sectional view showing a first example of the touch input device configured to detect a touch position and a touch pressure in accordance with the embodiment. In the touch input device 1000 including a display module 200, a pressure detection module 400 and the touch sensor panel 100 which detects the touch position may be attached to the front side of the display panel 200. Accordingly, it is possible to protect a display screen of the display panel 200 and to increase a touch detection sensitivity of the touch sensor panel 100.

Here, the pressure detection module 400 may operate separately from the touch sensor panel 100 which detects the touch position. For example, the pressure detection module 400 may detect only the pressure independently of the touch sensor panel 100 which detects the touch position. Also, the pressure detection module 400 may be configured to be coupled to the touch sensor panel 100 which detects the touch position and to detect the touch pressure. For example, at least one of the drive electrode TX and the receiving electrode RX included in the touch sensor panel 100 which detects the touch position may be used to detect the touch pressure.

Fig. 3a shows that the pressure detection module 400 is coupled to the touch sensor panel 100 and detects the touch pressure. In Fig. 3a, the pressure detection module 400 includes a spacer layer 420 which leaves a space between the touch sensor panel 100 and the display module 200. The pressure detection module 400 may include a reference potential layer spaced from the touch sensor panel 100 by the spacer layer 420. Here, the display module 200 may function as the reference potential layer.

The reference potential layer may have any potential which causes the change of the capacitance 101 generated between the drive electrode TX and the receiving electrode RX. For instance, the reference potential layer may be a ground layer having a ground potential. The reference potential layer may be the ground layer of the display module 200. Here, the reference potential layer may have a parallel plane with the two-dimensional plane of the touch sensor panel 100.

As shown in Fig. 3a, the touch sensor panel 100 is disposed apart from the display module 200, i.e., the reference potential layer. Here, depending on a method for adhering the touch sensor panel 100 to the display module 200, the spacer layer 420 may be implemented in the form of an air gap between the touch sensor panel 100 and the display module 200. The spacer layer 420 may be made of an impact absorbing material in accordance with the embodiment. Here, the impact absorbing material may include sponge and a graphite layer. The spacer layer 420 may be filled with a dielectric material in accordance with the embodiment. The spacer layer 420 may be formed through a combination of the air gap, the impact absorbing material, and the dielectric material.

Here, a double adhesive tape (DAT) 430 may be used to fix the touch sensor panel 100 and the display module 200. For example, the areas the touch sensor panel 100 and the display module 200 are overlapped with each other. The touch sensor panel 100 and the display module 200 are adhered to each other by adhering the edge portions of the touch sensor panel 100 and the display module 200 through use of the DAT 430, and the rest portions of the touch sensor panel 100 and the display module 200 may be spaced apart from each other by a predetermined distance " d ". Also, according to the embodiment, the touch sensor panel 100 and the display module 200 may be fixed to be spaced apart from each other by a predetermined distance " d " by a predetermined fixing member.

In general, even when the touch surface is touched without bending the touch sensor panel 100, the capacitance (Cm) 101 between the drive electrode TX and the receiving electrode RX is changed. That is, when the touch occurs on the touch sensor panel 100, the mutual capacitance (Cm) 101 may become smaller than a base mutual capacitance. This is because, when the conductive object like a finger approaches close to the touch sensor panel 100, the object functions as the ground GND, and then a fringing capacitance of the mutual capacitance (Cm) 101 is absorbed in the object. The base mutual capacitance is the value of the mutual capacitance between the drive electrode TX and the receiving electrode RX when there is no touch on the touch sensor panel 100.

When the object touches the top surface, i.e., the touch surface of the touch sensor panel 100 and a pressure is applied to the top surface, the touch sensor panel 100 may be bent. Here, the value of the mutual capacitance (Cm) 101 between the drive electrode TX and the receiving electrode RX may be more reduced. This is because the bend of the touch sensor panel 100 causes the distance between the touch sensor panel 100 and the reference potential layer to be reduced from " d " to " d' ", so that the fringing capacitance of the mutual capacitance (Cm) 101 is absorbed in the reference potential layer as well as in the object. When a nonconductive object touches, the change of the mutual capacitance (Cm) 101 is simply caused by only the change of the distance "d-d' " between the touch sensor panel 100 and the reference potential layer.

As described above, the touch input device 1000 is configured to include the touch sensor panel 100 and the pressure detection module 400 on the display module 200, so that not only the touch position but also the touch pressure can be simultaneously detected.

The foregoing has shown that the touch position and touch pressure are detected by the mutual capacitance. Besides, according to the embodiment, the touch position and touch pressure may be also detected by the self-capacitance. According to the embodiment, it may be possible that the touch position is detected by the mutual capacitance and the touch pressure is detected by the self-capacitance. Alternatively, it may be possible that touch position is detected by the self-capacitance and the touch pressure is detected by the mutual capacitance.

However, as shown in Fig. 3a, when the pressure detection module 400 as well as the touch sensor panel 100 is disposed on the display module 200, the display properties of the display panel is deteriorated. Particularly, when the air gap is included on the display module 200, the visibility and optical transmittance of the display panel may be lowered.

Accordingly, in order to prevent such problems, the air gap is not disposed between the display module 200 and the touch sensor panel 100 for detecting the touch position. Instead, the touch sensor panel 100 and the display module 200 can be fully laminated by means of an adhesive like an optically clear adhesive (OCA).

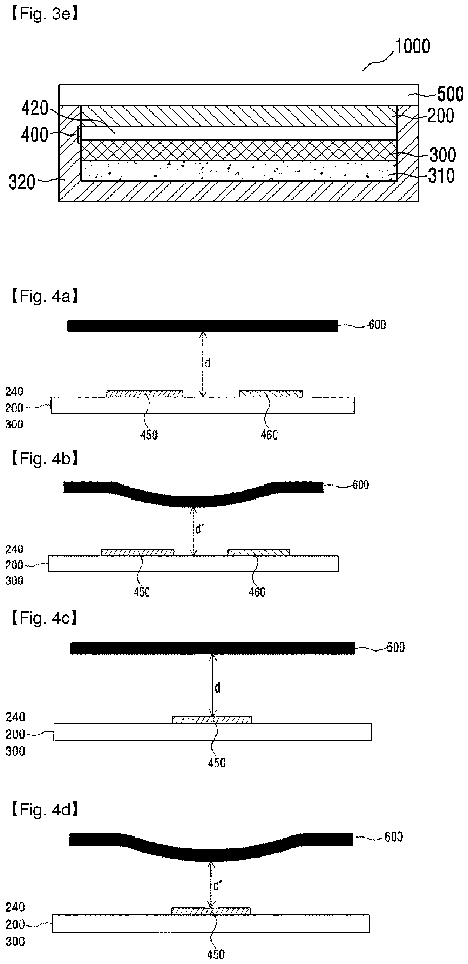

Although the following Figs. 3b and 3e do not show the touch sensor panel 100 separately, the touch sensor panel 100 of the touch input device 1000 according to the embodiment may be located outside or inside the display module 200.

Fig. 3b is a cross sectional view showing a second example of the touch input device configured to detect the touch position and the touch pressure in accordance with the embodiment. The cross sectional view of the touch input device 1000 shown in Fig. 3b may be a cross sectional view of a portion of the touch input device 1000. As shown in Fig. 3b, the touch input device 1000 according to the embodiment of the present invention may include the display panel 200A, a backlight unit 200B disposed under the display panel 200A, and a cover layer 500 disposed on the display panel 200A. In the touch input device 1000 according to the embodiment, the pressure sensors 450 and 460 may be formed on a first support member 240. In this specification, the display panel 200A and the backlight unit 200B are collectively referred to as the display module 200. Fig. 3b shows that the pressure sensors 450 and 460 are attached on the first support member 240. However, according to the embodiment, the pressure sensors 450 and 460 can be also attached to a configuration which is included in the touch input device 1000 and performs the same or similar function as/to that of the first support member 240.

The touch input device 1000 according to the embodiment may include an electronic device including a touch screen, for example, a cell phone, a personal data assistant (PDA), a smart phone, a tablet personal computer, an MP3 player, a laptop computer, etc.

At least a portion of the touch sensor is included within the display panel 200A in the touch input device 1000 according to the embodiment. Also, according to the embodiment, the drive electrode and the receiving electrode which are for sensing the touch may be included within the display panel 200A.

The cover layer 500 according to the embodiment may be comprised of glass which protects the front side of the display panel 200A and forms the touch surface. The cover layer 500 may perform a function to protect the display panel 200A. In the embodiment, the cover layer 500 may be comprised of a transparent material in order that not only the display panel 200A is protected from the external environment but also the display is visually checked. For example, the cover layer 500 may be composed of a material such as glass or plastic or may be composed of a material other than glass/plastic. As shown in Fig. 3b, the cover layer 500 may be formed wider than the display panel 200A.

Since the display panel 200A such as the LCD panel according to the embodiment performs a function of only blocking or transmitting the light without emitting light by itself, the backlight unit 200B may be required. For example, the backlight unit 200B is disposed under the display panel 200A, includes a light source and throws the light on the display panel 200A, so that not only brightness and darkness but also information having a variety of colors is displayed on the screen. Since the display panel 200A is a passive device, it is not self-luminous. Therefore, the rear side of the display panel 200A requires a light source having a uniform luminance distribution.

The backlight unit 200B according to the embodiment may include an optical layer 220 for illuminating the display panel 200A. The optical layer 220 will be described in detail with reference to Fig. 3c.

The backlight unit 200B according to the embodiment may include the first support member 240. The first support member 240 may be a frame made of a metallic material. When a pressure is applied from the outside through the cover layer 500 of the touch input device 1000, the cover layer 500, the display module 200, etc., may be bent. Here, the bending causes a distance between the pressure sensor 450 and 460 and a reference potential layer located within the display module to be changed. The capacitance change caused by the distance change is detected through the pressure sensors 450 and 460, so that the magnitude of the pressure can be detected. Here, a pressure is applied to the cover layer 500 in order to precisely detect the magnitude of the pressure, the positions of the pressure sensors 450 and 460 need to be fixed without changing. Therefore, the first support member 240 may be less bent than the cover layer 500 and/or the display panel 200A, etc., and may perform a function of a support capable of fixing a pressure sensor without being bent even by the application of pressure. According to the embodiment, the first support member 240 is manufactured separately from the backlight unit 200B, and may be assembled together when the display module is manufactured.

In the touch input device 1000 according to the embodiment, a first air gap 210 may be included between the display panel 200A and the backlight unit 200B. This intends to protect the display panel 200A and/or the backlight unit 200B from an external impact. This first air gap 210 may be included in the backlight unit 200B.

The optical layer 220 and the first support member 240, which are included in the backlight unit 200B, may be configured to be spaced apart from each other. A second air gap 230 may be provided between the optical layer 220 and the first support member 240. The second air gap 230 may be required in order to ensure that the pressure sensors 450 and 460 disposed on the first support member 240 does not contact with the optical layer 220, and in order to prevent that the optical layer 220 contacts with the pressure sensors 450 and 460 and deteriorates the performance of the optical layer 220 even though an external pressure is applied to the cover layer 500 and the optical layer 220, the display panel 200A, and the cover layer 500 are bent.

The touch input device 1000 according to the embodiment may further include second support members 251 and 252 such that the display panel 200A, the backlight unit 200B, and the cover layer 500 are coupled to maintain a fixed shape. According to the embodiment, the first support member 240 may be integrally formed with the second support members 251 and 252. According to the embodiment, the second support members 251 and 252 may form a portion of the backlight unit 200B.

The structure and function of the LCD panel 200A and the backlight unit 200B is a publicly known art and will be briefly described below. The backlight unit 200B may include several optical parts.

Fig. 3c shows the optical layer 220 of the backlight unit 200B in the touch input device according to the embodiment. Fig. 3c shows the optical layer 220 when the LCD panel is used as the display panel 200A.

In Fig. 3c, the optical layer 220 of the backlight unit 200B may include a reflective sheet 221, a light guide plate 222, a diffuser sheet 223, and a prism sheet 224. Here, the backlight unit 200B may include a light source (not shown) which is formed in the form of a linear light source or point light source and is disposed on the rear and/or side of the light guide plate 222.

The light guide plate 222 may generally convert lights from the light source (not shown) in the form of a linear light source or point light source into light from a light source in the form of a surface light source, and allow the light to proceed to the LCD panel 200A.

A part of the light emitted from the light guide plate 222 may be emitted to a side opposite to the LCD panel 200A and be lost. The reflective sheet 221 may be positioned under the light guide plate 222 so as to cause the lost light to be incident again on the light guide plate 222, and may be made of a material having a high reflectance.

The diffuser sheet 223 functions to diffuse the light incident from the light guide plate 222. For example, light scattered by the pattern of the light guide plate 222 comes directly into the eyes of the user, and thus, the pattern of the light guide plate 222 may be shown as it is. Moreover, since such a pattern can be clearly sensed even after the LCD panel 200A is mounted, the diffuser sheet 223 is able to perform a function to offset the pattern of the light guide plate 222.

After the light passes through the diffuser sheet 223, the luminance of the light is rapidly reduced. Therefore, the prism sheet 224 may be included in order to improve the luminance of the light by focusing the light again. The prism sheet 224 may include, for example, a horizontal prism sheet and a vertical prism sheet.

The backlight unit 200B according to the embodiment may include a configuration different from the above-described configuration in accordance with the technical change and development and/or the embodiment. The backlight unit 200B may further include an additional configuration as well as the foregoing configuration. Also, in order to protect the optical configuration of the backlight unit 200B from external impacts and contamination, etc., due to the introduction of the alien substance, the backlight unit 200B according to the embodiment may further include, for example, a protection sheet on the prism sheet 224. The backlight unit 200B may also further include a lamp cover in accordance with the embodiment so as to minimize the optical loss of the light source. The backlight unit 200B may also further include a frame which maintains a shape enabling the light guide plate 222, the diffuser sheet 223, the prism sheet 224, a lamp (not shown), and the like, which are main components of the backlight unit 200B, to be exactly combined together in accordance with an allowed dimension. Also, the each of the configurations may be comprised of at least two separate parts.

According to the embodiment, an additional air gap may be positioned between the light guide plate 222 and the reflective sheet 221. As a result, the lost light from the light guide plate 222 to the reflective sheet 221 can be incident again on the light guide plate 222 by the reflective sheet 221. Here, between the light guide plate 222 and the reflective sheet 221, for the purpose of maintaining the additional air gap, the double adhesive tape (DAT) may be included on the edges of the light guide plate 222 and the reflective sheet 221. Further, according to the embodiment, the light guide plate 222 and the reflective sheet 221 may be disposed apart from each other by any other fixing member.

As described above, the backlight unit 200B and the display module including the backlight unit 200B may be configured to include in itself the air gap such as the first air gap 210 and/or the second air gap 230. Also, the air gap may be included between a plurality of the layers included in the optical layer 220. Although the foregoing has described that the LCD panel 200A is used, the air gap may be included within the structure of another display panel.

Fig. 3d is a cross sectional view showing a third example of the touch input device configured to detect the touch position and the touch pressure in accordance with the embodiment. Fig. 3d shows a cross section of the touch input device 1000 that further includes a substrate 300 as well as the display module 200. In the touch input device 1000 according to the embodiment, the substrate 300, together with a second outermost cover 320 of the touch input device 1000, functions as, for example, a housing which surrounds a mounting space 310, etc., where the circuit board and/or battery for operation of the touch input device 1000 are located. Here, the circuit board for operation of the touch input device 1000 may be a main board. A central processing unit (CPU), an application processor (AP) or the like may be mounted on the circuit board. Due to the substrate 300, the display module 200 is separated from the circuit board and/or battery for operation of the touch input device 1000. Due to the substrate 300, electrical noise generated from the display module 200 can be blocked. According to the embodiment, the substrate 300 may be referred to as a mid-frame in the touch input device 1000.

As shown in Fig. 3e, in the touch input device 1000, the cover layer 500 may be formed wider than the display module 200, the substrate 300, and the mounting space 310. As a result, the second cover 320 is formed in such a manner as to surround the display module 200, the substrate 300, and the mounting space 310 where the circuit board is located.

The touch input device 1000 according to the embodiment may detect the touch position through the touch sensor panel 100 and include the pressure detection module 400 between the display module 200 and the substrate 300.

Here, the pressure sensor included in the pressure detection module 400 may be formed on the substrate 300, may be formed on the display module 200, or may be formed on the display module 200 and the substrate 300. Also, the electrode 450 and 460 constituting the pressure sensor included in the pressure detection module 400 may be included in the touch input device 1000 in the form of an electrode sheet 440 including the corresponding electrode. This will be described below in detail.

As shown in Figs. 3b and 3d, since the pressure detection module 400 in the touch input device 1000 is disposed between the display module 200 and the substrate 300 and under the display module 200, the electrode constituting the pressure sensor included in the pressure detection module 400 can be made of not only a transparent material but also an opaque material. Hereafter, in the touch input device 1000 according to the embodiment of the present invention, the principle and structure for detecting the magnitude of touch pressure by using the pressure sensors 450 and 460 will be described in detail.

Figs. 4a and 4b show a relative distance between a reference potential layer and a pressure sensor of a first example which are included in the touch input device, and show a pressure is applied to the touch input device.

In the touch input device 1000 according to the embodiment of the present invention, the pressure sensors 450 and 460 may be attached on the first support member 240 capable of constituting the backlight unit 200B. In the touch input device 1000, the pressure sensors 450 and 460 and the reference potential layer 600 may be spaced apart from each other by a distance "d".

In Fig. 4a, the reference potential layer 600 and the pressure sensors 450 and 460 may be spaced apart from each other with a spacer layer (not shown) placed therebetween. Here, as described with reference to Figs. 3b and 3c, the spacer layer may be the first air gap 210, the second air gap 230, and/or an additional air gap which are included in the manufacture of the display module 200 and/or the backlight unit 200B. When the display module 200 and/or the backlight unit 200B include one air gap, the one air gap is able to perform the function of the spacer layer. When the display module 200 and/or the backlight unit 200B includes a plurality of air gaps, the plurality of air gaps are able to collectively perform the function of the spacer layer.

In the touch input device 1000 according to the embodiment, the spacer layer may be located between the reference potential layer 600 and the pressure sensors 450 and 460. As a result, when a pressure is applied to the cover layer 500, the reference potential layer 600 is bent, so that a relative distance between the reference potential layer 600 and the pressure sensors 450 and 460 may be reduced.

In the touch input device 1000 according to the embodiment, the display module 200 may be bent or pressed by the touch applying the pressure. The display module may be bent or pressed in such a manner as to show the biggest transformation at the touch position. When the display module is bent or pressed according to the embodiment, a position showing the biggest transformation may not match the touch position. However, the display module may be shown to be at least bent or pressed by the touch. For example, when the touch position approaches close to the border, edge, etc., of the display module, the most bent or pressed position of the display module may not match the touch position.

When the cover layer 500, the display panel 200A, and/or the back light unit 200B are bent or pressed at the time of touching the touch input device 1000 according to the embodiment, the first support member 240 positioned under the spacer layer, as shown in Fig. 4b, may be less bent or pressed due to the spacer layer. While Fig. 4b shows that the first support member 240 is not bent or pressed at all, this is just an example. The lowest portion of the first support member 240 to which the pressure sensors 450 and 460 have been attached may be bent or pressed. However, the degree to which the lowest portion of the first support member 240 is bent or pressed can be reduced by the spacer layer.

According to the embodiment, the spacer layer may be implemented in the form of the air gap. The spacer layer may be made of an impact absorbing material in accordance with the embodiment. The spacer layer may be filled with a dielectric material in accordance with the embodiment.

Fig. 4b shows that a pressure is applied to the structure of Fig. 4a. For example, when the external pressure is applied to the cover layer 500 shown in Fig. 3b, it can be seen that a relative distance between the reference potential layer 600 and the pressure sensors 450 and 460 is reduced from "d" to " d' ". Accordingly, in the touch input device 1000 according to the embodiment, when the external pressure is applied, the reference potential layer 600 is configured to be more bent than the first support member 240 to which the pressure sensors 450 and 460 have been attached, so that it is possible to detect the magnitude of touch pressure.

Figs. 3b, 4a, and 4b show that a first electrode 450 and a second electrode 460 are included as the pressure sensors 450 and 460 for detecting the pressure. Here, the mutual capacitance may be generated between the first electrode 450 and the second electrode 460. Here, any one of the first and the second electrodes 450 and 460 may be a drive electrode and the other may be a receiving electrode. A driving signal is applied to the drive electrode, and a sensing signal may be obtained through the receiving electrode. When voltage is applied, the mutual capacitance may be generated between the first electrode 450 and the second electrode 460.

The reference potential layer 600 may have any potential which causes the change of the mutual capacitance generated between the first electrode 450 and the second electrode 460. For instance, the reference potential layer 600 may be a ground layer having a ground potential. The reference potential layer 600 may be any ground layer which is included in the display module. According to the embodiment, the reference potential layer 600 may be a ground potential layer which is included in itself during the manufacture of the touch input device 1000. For example, in the display panel 200 shown in Figs. 2a to 2c, an electrode (not shown) for blocking noise may be included between the first polarizer layer 271 and the first substrate layer 261. This electrode for blocking the noise may be composed of ITO and may function as the ground. Also, according to the embodiment, a plurality of the common electrodes included in the display panel 200 constitutes the reference potential layer 600. Here, the potential of the common electrode may be a reference potential.

When a pressure is applied to the cover layer 500 by means of an object, at least a portion of the display panel 200A and/or the backlight unit 200B is bent, so that a relative distance between the reference potential layer 600 and the first and second electrodes 450 and 460 may be reduced from "d" to " d' ". Here, the less the distance between the reference potential layer 600 and the first and second electrodes 450 and 460 is, the less the value of the mutual capacitance between the first electrode 450 and the second electrode 460 may be. This is because the distance between the reference potential layer 600 and the first and second electrodes 450 and 460 is reduced from "d" to " d' ", so that a fringing capacitance of the mutual capacitance is absorbed in the reference potential layer 600 as well as in the object. When a nonconductive object touches, the change of the mutual capacitance is simply caused by only the change of the distance " d-d' " between the reference potential layer 600 and the electrodes 450 and 460.

The foregoing has described that the first electrode 450 and the second electrode 460 are included as the pressure sensors 450 and 460, and the pressure is detected by the change of the mutual capacitance between the first electrode 450 and the second electrode 460. The pressure sensors 450 and 460 may be configured to include only any one of the first electrode 450 and the second electrode 460 (for example, the first electrode 450).

Figs. 4c and 4d show a relative distance between a reference potential layer and a pressure sensor of a second example which are included in the touch input device, and show that a pressure is applied to the touch input device. Here, it is possible to detect the magnitude of touch pressure by detecting the self-capacitance between the first electrode 450 and the reference potential layer 600. Here, the change of the self-capacitance between the first electrode 450 and the reference potential layer 600 is detected by applying the driving signal to the first electrode 450 and by receiving the reception signal from the first electrode 450, so that the magnitude of the touch pressure is detected.

For example, the magnitude of the touch pressure can be detected by the change of the capacitance between the first electrode 450 and the reference potential layer 600, which is caused by the distance change between the reference potential layer 600 and the first electrode 450. Since the distance "d " is reduced with the increase of the touch pressure, the capacitance between the reference potential layer 600 and the first electrode 450 may be increased with the increase of the touch pressure.

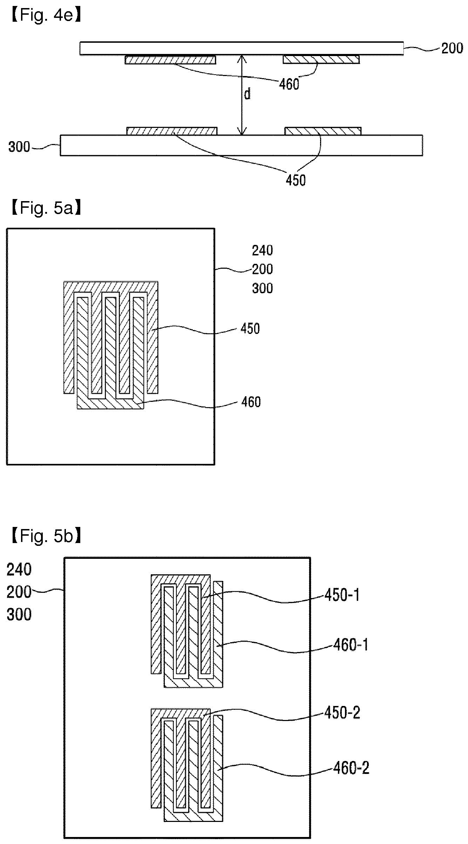

According to the embodiment, when the magnitude of the touch pressure is sufficiently large, a state may be created in which the distance between the reference potential layer 600 and the pressure sensors 450 and 460 is not reduced any more at a predetermined position. Hereafter, this state will be referred to as a saturation state. However, even in this case, when the magnitude of the touch pressure becomes larger, an area in the saturation state where the distance between the reference potential layer 600 and the pressure sensors 450 and 460 is not reduced any more may become greater. The greater the area is, the more the mutual capacitance between the first electrode 450 and the second electrode 460 may be reduced. Hereafter, it will be described that the magnitude of the touch pressure is calculated by the change of the capacitance according to the distance change. However, this may include that the magnitude of the touch pressure is calculated by the change of the area in the saturation state. This may be applied to embodiments related to Fig. 4e.

Figs. 3b and 4a to 4d show that the first electrode 450 and/or the second electrode 460 are relatively thick and they are directly attached to the first support member 240. However, this is just only for convenience of description. In accordance with the embodiment, the first electrode 450 and/or the second electrode 460 may be, for example, attached to the first support member 240 in the form of an integral sheet and may have a relatively small thickness.

Although the foregoing has described that the pressure sensors 450 and 460 are attached to the first support member 240 by referencing the touch input device 1000 shown in Figs. 3d and 3e, the pressure sensors 450 and 460 may be disposed between the display module 200 and the substrate 300 in the touch input device 1000 shown in Fig. 3c. According to the embodiment, the pressure sensors 450 and 460 may be disposed under the display module 200. In this case, the reference potential layer 600 may be the substrate 300 or any potential layer which is disposed within the display module 200. Also, according to the embodiment, the pressure sensors 450 and 460 may be attached to the substrate 300. In this case, the reference potential layer 600 may be any potential layer which is disposed on or within the display module 200.

Fig. 4e shows the arrangement of pressure sensors of a third example which is included in the touch input device. As shown in Fig. 4e, the first electrode 450 out of the pressure sensors 450 and 460 may be disposed on the substrate 300, and the second electrode 460 may be disposed under the display module 200. In this case, a separate reference potential layer may not be required. When a pressure touch is performed on the touch input device 1000, a distance between the display module 200 and the substrate 300 may be changed, and thus, the mutual capacitance between the first electrode 450 and the second electrode 460 may be increased. Through the capacitance change, the magnitude of the touch pressure can be detected.

Figs. 5a to 5e show patterns according to first to fifth examples of an electrode constituting the pressure sensor according to the embodiment.

Fig. 5a shows that a pattern according to the first example of a pressure electrode when the touch pressure is detected through the change of the mutual capacitance between the first electrode 450 and the second electrode 460. When the magnitude of the touch pressure is detected as the mutual capacitance between the first electrode 450 and the second electrode 460 is changed, it is necessary to form the patterns of the first electrode 450 and the second electrode 460 so as to generate the range of the capacitance required to improve the detection accuracy. With the increase of a facing area or facing length of the first electrode 450 and the second electrode 460, the size of the capacitance that is generated may become larger. Therefore, the pattern can be designed by adjusting the size of the facing area, facing length and facing shape of the first electrode 450 and the second electrode 460 in accordance with the range of the necessary capacitance. Fig. 5a shows a pressure electrode pattern having a comb teeth shape such that the facing length of the first electrode 450 and the second electrode 460 becomes longer.

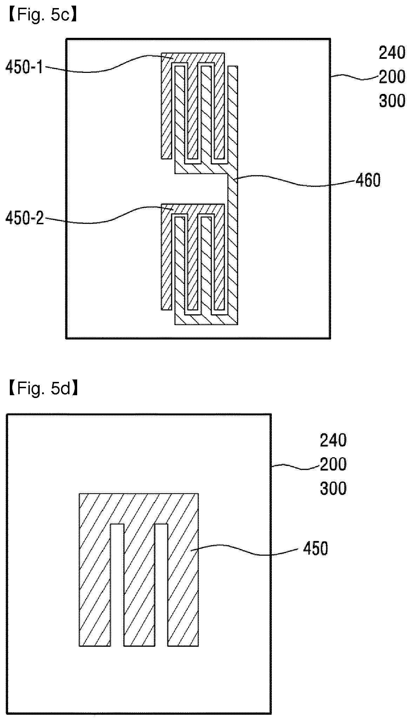

Fig. 5a shows that the first electrode 450 and the second electrode 460 constitute one channel for detecting the pressure. Fig. 5b shows a pattern of a case in which the pressure sensor constitutes two channels. Fig. 5b shows a first electrode 450-1 and a second electrode 460-1 which constitute a first channel, and a first electrode 450-2 and a second electrode 460-2 which constitute a second channel. Fig. 5c shows that the first electrode 450 constitutes two channels 450-1 and 450-2, and the second electrode 460 constitutes one channel. Since the pressure sensor detects the magnitude of the touch pressure at different positions through the first channel and the second channel, even when a multi touch occurs, the magnitude of each touch pressure can be detected. Here, in accordance with the embodiment, the pressure sensors 450 and 460 may be configured to constitute a larger number of channels.

Fig. 5d shows an electrode pattern when the size of the touch pressure is detected according to the change of the self-capacitance between the reference potential layer 600 and the first electrode 450. Although Fig. 5d shows a pattern having a comb teeth shape as the first electrode 450, the first electrode 450 may have a plate shape (for example, a quadrangular shape, a circular shape, etc.).

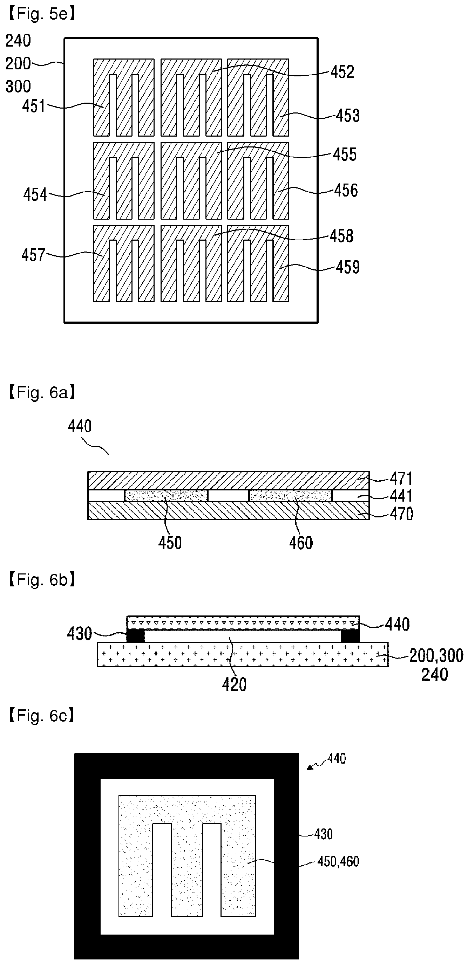

Fig. 5e shows that the first electrode constitutes nine channels 451 to 459. That is, Fig. 5d shows that one channel is constituted, and Fig. 5e shows a pressure sensor when nine channels are constituted. Therefore, in Fig. 5e, even when a multi touch occurs, the size of each touch pressure can be detected. Here, the pressure sensor can be configured to constitute another number of the channels.

In the embodiment, the pressure sensors 450 and 460 may include a plurality of electrodes forming a plurality of channels. Also, in the embodiment, a plurality of touch pressures can be detected by using the plurality of channels.

Fig. 6a is a cross sectional view of an exemplary electrode sheet which includes a pressure electrode and is to be attached to the touch input device according to the embodiment. For example, the electrode sheet 440 may include an electrode layer 441 between a first insulation layer 470 and a second insulation layer 471. The electrode layer 441 may include the first electrode 450 and/or the second electrode 460. Here, the first insulation layer 470 and the second insulation layer 471 may be made of an insulating material like polyimide, Polyethylene Terephthalate (PET), etc. The first electrode 450 and the second electrode 460 included in the electrode layer 441 may include a material like copper, aluminum (Al), silver (Ag), etc. According to the manufacturing process of the electrode sheet 440, the electrode layer 441 and the second insulation layer 471 may be bonded to each other by an adhesive (not shown) like an optically clear adhesive (OCA). Also, according to the embodiment, the pressure electrodes 450 and 460 may be formed by positioning a mask, which has a through-hole corresponding to a pressure electrode pattern, on the first insulation layer 470, and then by spraying a conductive material or by printing the conductive material, or by applying a metallic material and etching.

In order that the touch pressure is detected in the touch input device 1000 according to the embodiment, the integral electrode sheet 440 including at least one pressure electrode 450 and 460 may be attached, as the pressure sensor, to the substrate 300, the display module 200, or the first support member 240 in such a manner as to be spaced apart from the substrate 300, the display module 200, or the first support member 240, with the spacer layer 420 placed therebetween. The electrode sheet 440 may be attached to the touch input device 1000 not only by a method to be described below with reference to Figs. 6b to 6d but also by various methods which are applied to the structure of Figs. 3a to 3d and are capable of detecting the pressure.

Fig. 6b is a cross sectional view showing a portion of the touch input device to which the electrode sheet has been attached according to a first method. Fig. 6bb shows that the electrode sheet 440 has been attached on the substrate 300, the display module 200, or the first support member 240. As shown in Fig. 6c, the adhesive tape 430 having a predetermined thickness may be formed along the border of the electrode sheet 440 so as to maintain the spacer layer 420. Though Fig. 6c shows that the adhesive tape 430 is formed along the entire border (for example, four sides of a quadrangle) of the electrode sheet 440, the adhesive tape 430 may be formed only on at least a portion (for example, three sides of a quadrangle) of the border of the electrode sheet 440. Here, as shown in Fig. 6c, the adhesive tape 430 may not be formed on an area including the pressure electrodes 450 and 460. As a result, when the electrode sheet 440 is attached to the substrate 300 or the display module 200 through the adhesive tape 430, the pressure electrodes 450 and 460 may be spaced apart from the substrate 300 or the display module 200 at a predetermined distance. According to the embodiment, the adhesive tape 430 may be formed on the top surface of the substrate 300, the bottom surface of the display module 200, the surface of the first support member 240. Also, the adhesive tape 430 may be a double adhesive tape. Fig. 6c shows only one of the pressure electrodes 450 and 460. According to the embodiment, the pressure sensor may be constituted by including the electrode forming the plurality of channels in one electrode sheet 440.

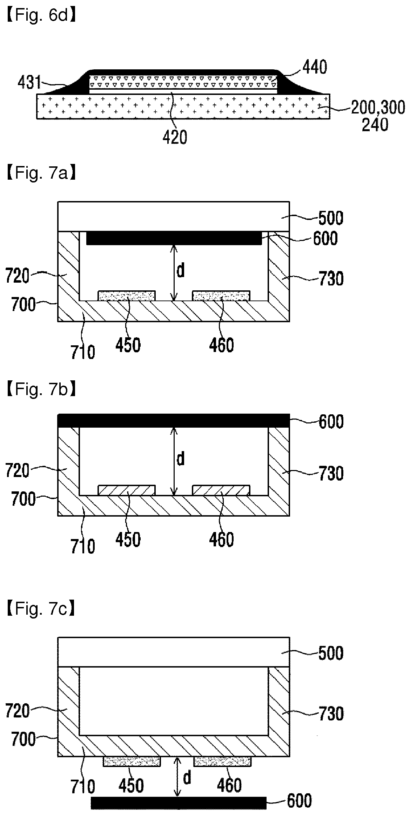

Fig. 6d is a partial cross sectional view of the touch input device to which the electrode sheet 440 has been attached according to a second method. In Fig. 6d, after the electrode sheet 440 is placed on the substrate 300, the display module 200, or the first support member 240, the electrode sheet 440 may be fixed to the substrate 300, the display module 200, or the first support member 240 by means of the adhesive tape 431. For this, the adhesive tape 431 may come in contact with at least a portion of the electrode sheet 440 and at least a portion of the substrate 300, the display module 200, or the first support member 240. Fig. 6d shows that the adhesive tape 431 continues from the top of the electrode sheet 440 to the exposed surface of the substrate 300, the display module 200, or the first support member 240. Here, only a portion of the adhesive tape 431, which contacts with the electrode sheet 440, may have adhesive strength. Therefore, in Fig. 6d, the top surface of the adhesive tape 431 may not have the adhesive strength.

As shown in Fig. 6d, even if the electrode sheet 440 is fixed to the substrate 300, the display module 200, or the first support member 240 by using the adhesive tape 430, a predetermined space, i.e., air gap may be created between the electrode sheet 440 and the substrate 300, the display module 200, or the first support member 240. This is because the substrate 300, the display module 200, or the first support member 240 is not directly attached to the electrode sheet 440 by means of the adhesive and because the electrode sheet 440 includes the pressure electrodes 450 and 460 having a pattern, so that the surface of the electrode sheet 440 may not be flat. The air gap of Fig. 6d may also function as the spacer layer 420 for detecting the touch pressure.

In the foregoing, the touch input device 1000 capable of detecting the touch position and/or the touch pressure in accordance with the embodiment has been described. Hereinafter, the touch input device capable of enhance a pressure detection sensitivity in accordance with the embodiment will be described.

The touch input device 1000 according to the embodiment of the present invention may include an intermediate device 700 in which a through-hole 740 has been formed. The through-hole 740 allows air to smoothly flow at the time of touching the touch surface by applying a pressure to the touch surface. Here, the through-hole 740 may be an air-hole through which the air can flow.

Figs. 7a to 7e show the first to the fifth example showing an arrangement relationship between the reference potential layer and the intermediate device 700 in the touch input device according to the embodiment of the present invention.

In the touch input device 1000 according to the embodiment of the present invention, in order that the distance between the reference potential layer 600 and the pressure sensors 450 and 460 is easily changed by applying the touch pressure, the intermediate device 700 may be formed to include the through-hole through which the air can flow. In this specification, the intermediate device 700 may be any member which is located within an outermost device, housing, case, etc., of the touch input device 1000.

As shown in Fig. 7a, the intermediate device 700 according to the embodiment is coupled to the cover layer 500, so that the reference potential layer 600 and the pressure sensors 450 and 460 are included in an interior space formed by the coupling of the intermediate device 700 and the cover layer 500. This is just an example. The intermediate device 700, together with other components as well as the cover layer 500, may form an interior space where the reference potential layer 600 and the pressure sensors 450 and 460 are included.

Fig. 7a shows that the reference potential layer 600 is disposed to contact the cover layer 500. However, this is just an example. It is enough as long as the reference potential layer 600 is disposed in the interior space formed by the intermediate device 700 and the cover layer 500. Likewise, Fig. 7a shows that the pressure sensors 450 and 460 are also disposed to contact the intermediate device 700. However, the pressure sensors 450 and 460 do not necessarily need to be disposed to contact the intermediate device 700. It is enough as long as the pressure sensors 450 and 460 are disposed in the interior space formed by the intermediate device 700 and the cover layer 500.

Also, according to the embodiment, as shown in Fig. 7b, the intermediate device 700 according to the embodiment is coupled to the reference potential layer 600, so that the pressure sensors 450 and 460 are included in an interior space formed by the coupling of the intermediate device 700 and the reference potential layer 600. This is just an example. The intermediate device 700, together with not only the reference potential layer 600 but also a component including the reference potential layer 600 or a component attached directly/indirectly to the reference potential layer 600, may form an interior space where the pressure sensors 450 and 460 are included.

Fig. 7b shows that the pressure sensors 450 and 460 are disposed to contact the intermediate device 700. However, the pressure sensors 450 and 460 do not necessarily need to be disposed to contact the intermediate device 700. It is enough as long as the pressure sensors 450 and 460 are disposed in the interior space formed by the intermediate device 700 and the reference potential layer 600.

Fig. 7a shows that not only the reference potential layer 600 but also the pressure sensors 450 and 460 are included in the interior space formed by both the intermediate device 700 and the cover layer 500. However, according to the embodiment, only one of the reference potential layer 600 and the pressure sensors 450 and 460 may be included in the interior space. For example, the pressure sensors 450 and 460 may be disposed outside the intermediate device 700. Even in this case, the air is able to freely flow through the through-hole 740. Therefore, when a pressure is applied to the cover layer 500, the reference potential layer 600 can be easily bent.

Likewise, Fig. 7b shows that the pressure sensors 450 and 460 are included in the interior space formed by both the intermediate device 700 and the reference potential layer 600. However, according to the embodiment, the pressure sensors 450 and 460 may be disposed outside the intermediate device 700. Even in this case, the air is able to freely flow through the through-hole 740. Therefore, when a pressure is applied to the cover layer 500, the reference potential layer 600 can be easily bent.

Also, when a pressure is applied according to the embodiment, the intermediate device 700 may be disposed such that the member to which the pressure sensors 450 and 460 have been attached is more easily bent than the reference potential layer 600.

For instance, as shown in Fig. 7c, both the pressure sensors 450 and 460 and the reference potential layer 600 may be disposed in the outer space of the intermediate device 700. Fig. 7c shows that the pressure sensors 450 and 460 are disposed to contact the outer surface of the intermediate device 700. However, the pressure sensors 450 and 460 do not necessarily need to be attached to directly contact the intermediate device 700. Also, the pressure sensors 450 and 460 may be disposed at a position where a relative distance movement of the pressure sensors 450 and 460 is greater than that of the reference potential layer 600 in accordance with the applying of the touch pressure. In Fig. 7c, the reference potential layer 600 may be disposed in the outer space of the intermediate device 700 and be spaced apart from the pressure sensors 450 and 460 by the distance "d ". Even in this case, when a pressure is applied to the cover layer 500, the intermediate device 700, together with the cover layer 500, is bent and the relative distance between the reference potential layer 600 and the pressure sensors 450 and 460 is changed. When the touch is released, the air comes to be able to freely flow through the through-hole 740, so that the bent intermediate device 700 and the bent components disposed in the interior space of the intermediate device 700 can be quickly restored to their original state.

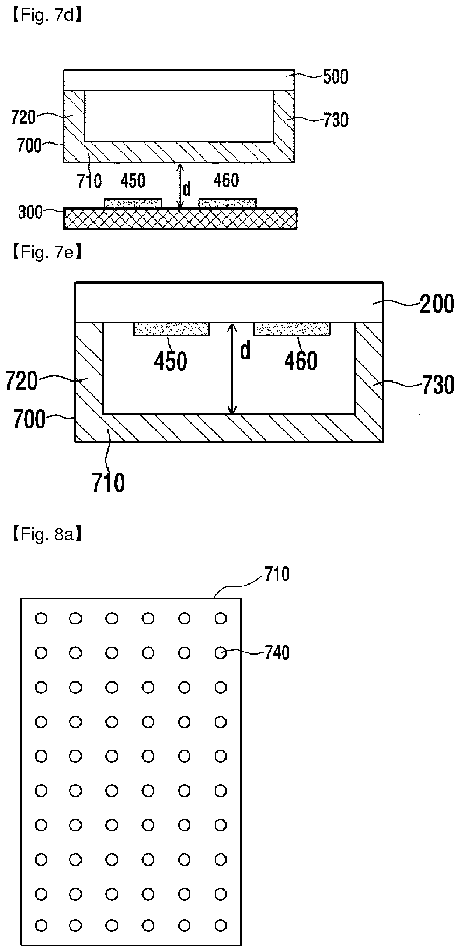

Also, as shown in Fig. 7d, the pressure sensors 450 and 460 may be disposed in the outer space of the intermediate device 700. Here, the reference potential layer 600 may be the intermediate device 700 itself or may be included in the interior space of the intermediate device 700. Alternatively, according to the embodiment, the reference potential layer 600 may be disposed at a position where the relative distance movement of the reference potential layer 600 is greater than that of the pressure sensor 450 and 460 in accordance with the applying of the touch pressure. Fig. 7d shows that the pressure sensors 450 and 460 are disposed on the substrate 300. However, the pressure sensors 450 and 460 do not necessarily need to be attached to directly contact the substrate 300. Even in this case, when a pressure is applied to the cover layer 500, the intermediate device 700, together with the cover layer 500, is bent and the relative distance between the reference potential layer 600 and the pressure sensors 450 and 460 is changed. When the touch is released, the air comes to be able to freely flow through the through-hole 740, so that the bent intermediate device 700 and the bent components disposed in the interior space of the intermediate device 700 can be quickly restored to their original state.

Also, when the pressure sensors 450 and 460 are arranged as shown in Fig. 4e, the intermediate device 700 having the through-hole 740 formed therein may be disposed such that at least one of the member to which the first electrode 450 is attached and the member to which the second electrode 460 is attached is easily bent.

Also, as shown in Fig. 7e, the pressure sensors 450 and 460 may be disposed both under the display module 200 or the display panel 200A and in the interior space of the intermediate device 700. According to the embodiment, the pressure sensors 450 and 460 may be attached to the bottom of the display module 200 or the display panel 200A. Here, the reference potential layer 600 may be the intermediate device 700 itself or may be included in the interior space of the intermediate device 700.

As shown in Figs. 7a to 7e, regarding the intermediate device 700, a lower member 710 and side members 720 and 730 may be integrally formed with each other. Also, according to the embodiment, the lower member 710 and the side members 720 and 730 are separate members and are coupled to each other, thereby forming the intermediate device 700.

Here, as shown in Figs. 8a to 8c, the intermediate device 700 of the touch input device 1000 according to the embodiment of the present invention may have the through-hole 740 formed therein. This causes that at least one of the reference potential layer 600 and the member to which the pressure sensors 450 and 460 have been attached is easily bent or at least one of the bent reference potential layer 600 and the bent member to which the pressure sensors 450 and 460 have been attached is easily restored to its original state.

For the purpose of maintaining the shape of the touch input device 1000 and of improving the durability of the touch input device 1000, the respective members constituting the touch input device 1000 may be integrally coupled to each other closely. Accordingly, when a pressure is applied to the touch input device 1000, the air does not flow freely and the reference potential layer 600 and/or the pressure sensors 450 and 460 may not be easily bent or the bent reference potential layer 600 and/or the bent pressure sensors 450 and 460 may not be easily restored to its original state. That is, in order to improve the accuracy of the touch pressure detection, it is necessary that not only the pressing/bending should occur easily by the applying of the touch pressure but also the restoration to the original state should be performed quickly after the pressure is released. If the air does not flow smoothly, a time required for the restoration to the original state may be increased. In this case, errors may occur in the detection of the subsequent touch pressure.

As a result, in the embodiment of the present invention, the through-hole 740 is formed in the intermediate device 700 included in the touch input device 1000, so that the air is allowed to freely move through the intermediate device 700. Therefore, the distance between the reference potential layer 600 and the pressure sensors 450 and 460 is not limited by the applying of the touch pressure, so that the detection accuracy of the pressure magnitude can be enhanced. Also, the detection of the subsequent touch is not inhibited because the restoration to its original state from the bending can be performed quickly.

The diameter of the through-hole 740 may be, for example, approximately several µm. Also, according to the embodiment, the through-hole 740 may have a diameter which allows the air to easily flow in and out in accordance with an air pressure change caused by the pressure touch and which prevents foreign substances with a diameter greater than 2.5 µm from passing the through-hole 740.

Figs. 8a to 8c show the first to the third examples showing the intermediate device having the through-hole formed therein in the touch input device according to the embodiment of the present invention. As shown in Fig. 8a, a plurality of the through-holes 740 may be formed in the lower portion 710 of the intermediate device 700. Also, according to the embodiment, the through-holes 740 may be uniformly formed throughout the entire area of the lower portion 710.

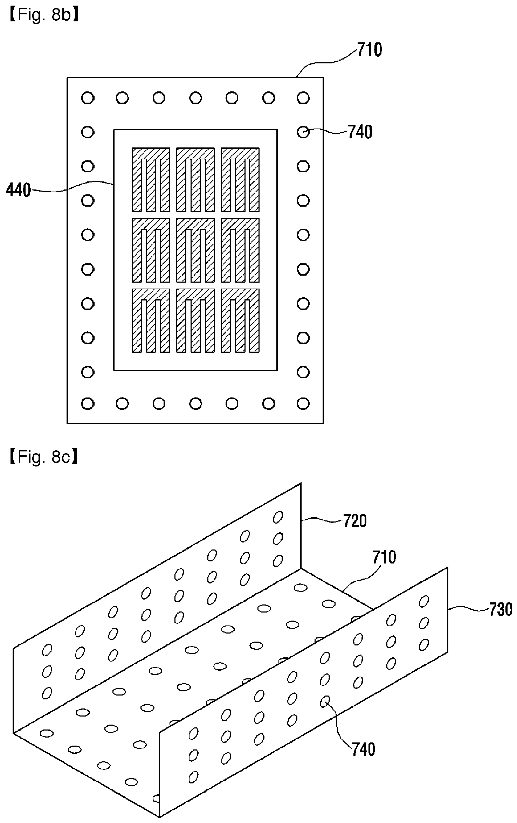

When the pressure sensors 450 and 460 or the electrode sheet 440 including the pressure sensors 450 and 460 is directly attached to the intermediate device 700, the air flow is interrupted by the electrode sheet 440 and the function of the electrode sheet 440 may be decreased. Therefore, as shown in Fig. 8b, the through-hole 740 may be formed only in the region where the electrode sheet 440 is not attached in the lower portion 710 of the intermediate device 700. Accordingly, the distance from the reference potential layer 600 to the entire area of the electrode sheet 440 can be uniformly maintained.

Also, according to the embodiment, as shown in Fig. 8c, the through-holes 740 are formed in the side members 720 and 730 as well as in the lower member 710 of the intermediate device 700, so that the air is able to flow more freely. According to the embodiment, the through-hole 740 may be formed only in the side members 720 and 730 of the intermediate device 700 such that the electrode sheets 440 of various sizes are attached to the lower member 710 of the intermediate device 700. In Fig. 8c, two side members are shown as the side members 720 and 730 of the intermediate device 700. However, according to the embodiment, the intermediate device 700 may include the side members 720 and 730 formed along the entire side thereof. Here, the through-hole 740 may be also formed in a portion of the side members 720 and 730.

In the embodiment of the present invention, the intermediate device 700 in which the through-hole 740 is formed may be the first support member 240 that is coupled to the second support members 251 and 252. According to the embodiment, the intermediate device 700 may be the substrate 300 which is coupled to any side member. According to the embodiment, the intermediate device 700 is any member included in the touch input device 1000 and may include the through-hole 740 which is formed to allow the distance between the reference potential layer 600 and the pressure sensors 450 and 460 to be easily changed by the applying of the touch pressure.

The foregoing has described that the pressure sensors 450 and 460 are separately provided outside the display panel 200A. The embodiment of the present invention can be applied not only to a case where the pressure sensors 450 and 460 are provided within the display panel 200A, but also to a case where an existing electrode included in the display panel 200A is used as the pressure sensor without providing the pressure sensors 450 and 460 separately. Also, the embodiment can be also applied to a case where the touch sensor 100 is used as the pressure sensors 450 and 460.

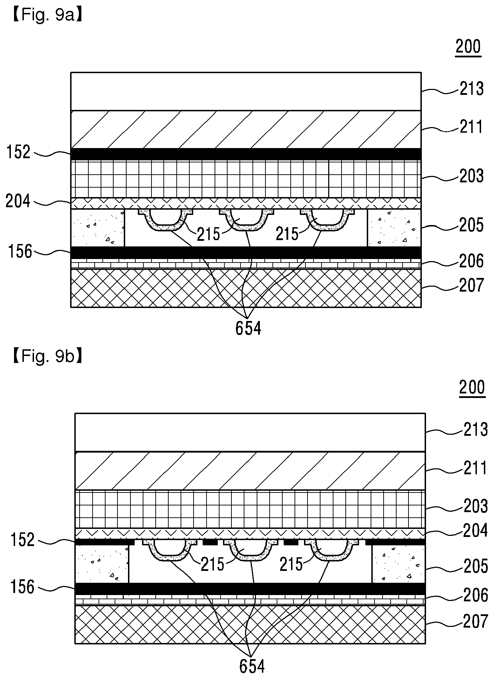

Figs. 9a to 9c show a structure in which the electrode for the pressure detection and touch position detection is located within the display panel. Hereinafter, the principle of detecting the touch position and the touch pressure is the same as or similar to that described above. Therefore, repetitive descriptions thereof will be omitted.

For example, in Figs. 9a to 9c, in the display panel 200A according to the embodiment of the present invention includes a first polarizer layer 201, a second electrode layer 152 on which a plurality of second electrodes R are formed, a first substrate layer 203 including a color filter, a liquid crystal layer 205 including a liquid crystal cell, a plurality of reference electrodes 654, a first and a third electrode layers 156 on which a plurality of first electrodes T and a plurality of third electrodes C are formed, a second substrate layer 207, and a second polarizer layer 209, all of which form a stack structure. Here, the position of the second electrode layer 152 and the position of the first substrate layer 203 including a color filter may be interchanged.

The display panel 200A according to the embodiment shown in Figs. 9a to 9c may be a display panel included in the liquid crystal display (LCD). Here, it can be considered that the display panel 200A is any one of a plane to line switching (PLS) display panel, an in plane switching (IPS) display panel, a vertical alignment (VA) display panel, and a twisted nematic (TN) display panel. Also, the display panel 200A according to the embodiment may be a display panel included in an organic light emitting diode (OLED), etc.

The plurality of the second electrodes R generate a first signal which is related to the touch position and has information on the capacitance which changes according to the touch. Also, the plurality of the third electrodes C generate a second signal which is related to the touch pressure and has information on the capacitance which changes according to the touch.

In Figs. 9a to 9c, the liquid crystal layer 205 includes the reference electrode 654. The reference electrode 654 may perform the same function as that of the reference potential layer 600. The first and the third electrode layers 156 are formed in contact with the liquid crystal layer 205. The mutual capacitance (Cm) is formed between the plurality of the first electrodes T and the plurality of the third electrodes C which are provided in the first and the third electrode layers 156.

As shown in Figs. 9a to 9c, the reference electrode 654 may be provided within the liquid crystal layer 205 in such a manner as to be spaced apart from the first and the third electrode layers 156. The reference electrode 654 may be formed by forming a conductive material layer on a part of or entire spacer 270 included in the liquid crystal layer 205. The first and the third electrode layers 156 may be formed on the layer provided with the reference electrode 654. However, according to the embodiment, the first and the third electrode layers 156 may be formed under the layer provided with the reference electrode 654.

In the case where the first and the third electrode layers 156 are formed under the layer provided with the reference electrode 654, when a pressure is applied to the touch surface of the display panel 200A by the touch of the object on the touch surface, the reference electrode 654 moves downward. Accordingly, the reference electrode 654 becomes closer to the first and the third electrode layers 156. Therefore, the mutual capacitance (Cm) between the first electrode T and the third electrode C is changed (reduced). However, when the reference electrode 654 is a floating node, the mutual capacitance (Cm) between the first electrode T and the third electrode C may increase.

Also, when the object touches the touch surface of the display panel 200A, the mutual capacitance (Cm) between the first electrode T provided to the first and the third electrode layers 156 and the second electrode R provided to the second electrode layer 152 is reduced.

Likewise, in the case where the first and the third electrode layers 156 are formed on the layer provided with the reference electrode 654, when a pressure is applied to the touch surface of the display panel 200A by the touch of the object on the touch surface, the first and the third electrode layers 156 move downward. Accordingly, the first and the third electrode layers 156 become closer to the reference electrode 654. Therefore, the mutual capacitance (Cm) between the first electrode T and the third electrode C is changed (reduced). However, when the reference electrode 654 is a floating node, the mutual capacitance (Cm) between the first electrode T and the third electrode C may increase.

On the basis of the change of the mutual capacitance (Cm), the first signal and the second signal which are capable of detecting the touch position and the touch pressure. Also, the second electrode R and the third electrode C are disposed in different layers, so that the first signal and the second signal can be generated at the same time.

However, in another embodiment, the pressure may be detected by the self-capacitance (Cs) change according to the distance between the first electrode T and the reference electrode 654. In other words, the pressure may be detected by the self-capacitance (Cs) change either between the first electrode T and the reference electrode 654 or between the third electrode C and the reference electrode 654.

The plurality of the first electrodes, the plurality of the second electrodes, and the plurality of the third electrodes may be made of a transparent conductive material (e.g., Indium Tin Oxide (ITO) or Antimony Tin Oxide (ATO) which is formed of tin oxide (SnO₂) and indium oxide (In₂O₃), etc.).

The display panel 200A according to the embodiment of Fig. 9a shows that the second electrode layer 152 is disposed on the first substrate layer 203. Fig. 9a shows a topmost cover layer 113 and an optically clear adhesive (OCA) layer 211 for adhering the cover layer 113. In Fig. 9a, a color filter layer 204 is shown separately from the first substrate 203, and a TFT layer 206 is shown separately from the second substrate layer 207.

Here, the reference electrode 654 does not necessarily have to be formed on the top surface of the liquid crystal layer 205 if the reference electrode 654 is formed at a position where the distance between the reference electrode 654 and the first and the third electrode layers 156 is changed as bending occurs by the touch on the surface of the display panel 200A.

A spacer for obtaining an interval may be provided to the liquid crystal layer 205 of the display panel 200A. The spacer may be formed within the liquid crystal layer 205 or may be formed on an upper layer located on the liquid crystal layer 205. In the embodiment of the present invention, the reference electrode 654 may be formed by forming a conductive material such as ITO on the spacer.

In the embodiment, the reference electrode 654 may be formed by forming a conductive material on a portion of the spacer instead of the entire spacer. Also, separately from the spacer, the conductive material-made reference electrode 654 may be formed. That is to say, as long as the reference electrode 654 is able to function as an electrode which is spaced apart from the first and the third electrode layers 156 and capable of changing the mutual capacitance (Cm), the reference electrode 654 may be formed in any method.

Fig. 9b shows a layer structure of the display panel 200A according to another embodiment of the present invention. Unlike Fig. 9a, in the embodiment, the second electrode layer 152 including the plurality of the second electrodes R is formed in contact with the liquid crystal layer 205. Since the other components have been described with reference to Fig. 9a, descriptions thereof will be omitted.

Figs. 9a and 9b show various embodiments in which the first and the third electrode layers 156 and the second electrode layer 152 are spaced from each other such that the liquid crystal layer 205 is provided with the reference electrode 654 and is placed between the first and the third electrode layers 156 and the second electrode layer 152. As long as the first and the third electrode layers 156 and the second electrode layer 152 are spaced from each other such that the liquid crystal layer 205 includes the reference electrode 654 and is placed between the first and the third electrode layers 156 and the second electrode layer 152, the second electrode layer 152 or the first and the third electrode layers 156 is allowed to be formed differently from what is shown in Fig. 9a or Fig. 9b.

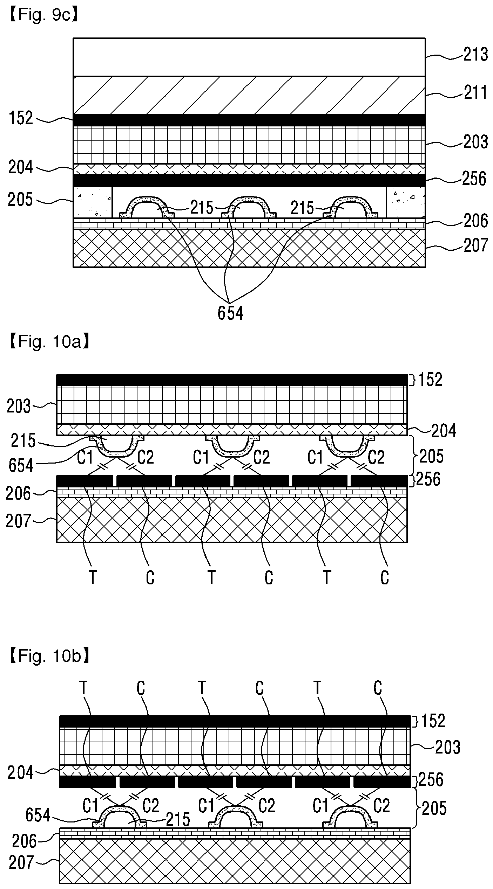

Meanwhile, unlike the embodiment of Fig. 9a or Fig. 9b, Fig. 9c shows a layer structure in which the reference electrode 654 is formed under the first and the third electrode layers 156. As shown in Fig. 9c, the reference electrode 654 of the display panel 200A is spaced apart from and formed under the first and the third electrode layers 156. Here, the reference electrode 654 may be formed at any position within the liquid crystal layer 205 if the reference electrode 654 is formed at a position where the distance between the reference electrode 654 and the first and the third electrode layers 156 is changed as bending occurs by the touch on the surface of the display panel 200A.

In also the embodiment of Fig. 9c, a spacer 215 for obtaining an interval may be provided in the liquid crystal layer 205 of the display panel 200A. The reference electrode 654 is formed under the first and the third electrode layers 156. The reference electrode 654 may be formed by forming a conductive material such as ITO on the spacer 215. Further, the reference electrode 654 may be formed by forming a conductive material on a portion of the spacer instead of the entire spacer 215.

Also, the conductive material-made reference electrode 654 may be formed separately from the spacer 215. That is to say, as long as the reference electrode 654 is able to function as an electrode which is spaced downward from the first and the third electrode layers 156 and capable of changing the mutual capacitance (Cm), the reference electrode 654 may be formed in any method. Figs. 10a and 10b show a structure in which the internal configuration of the display panel is used as the electrode for the pressure detection.

The TFT layer 206 is formed on the second substrate layer 207 of the display panel 200A according to the embodiment of the present invention shown in Fig. 10a. The TFT layer 206 includes electrical components required for generating an electric field driving the liquid crystal layer 205. Particularly, the TFT layer 206 may be composed of various layers including a data line, a gate line, a TFT, a common electrode, and a pixel electrode, etc. These electrical components may operate in such a manner as to generate a controlled electric field and to orient liquid crystals located in the liquid crystal layer 250.

In the embodiment of the present invention, the plurality of the first electrodes and the plurality of the third electrodes may use the common electrode included in the display panel 200A.

As shown in Fig. 10a, in the display panel 200A according to the embodiment of the present invention, a conductive material such as ITO is formed on the spacer 215 located above the first and the third electrode layers 156 and is used as the reference electrode 654. Although it has been described that the spacer 215 is provided in the liquid crystal layer 205, the spacer 215 may be formed in the first substrate layer 203 provided with the color filter layer 204. Here, the fringing capacitance C1 to the touch pressure signal may be formed between the reference electrode 654 and the plurality of the first electrodes T using the common electrode. The fringing capacitance C2 may be formed between the reference electrode 654 and the plurality of the third electrodes C using the common electrode.

As shown in Fig. 10a, in the display panel 200A according to the embodiment of the present invention, when a pressure is applied to the touch surface by the touch of the object on the touch surface, a distance between the reference electrode 654 and the TFT layer 206 is decreased, and thus, the distance between the reference electrode 654 and the plurality of the first and third electrodes T and C which are composed of low common electrodes is decreased. Accordingly, the mutual capacitance (Cm) is changed (decreased or increased). By the second signal generated as a result of this, the touch pressure can be detected.

In the embodiment of Fig. 10a, although it is shown that the second electrode layer 152 is formed on the first substrate layer 203, the second electrode layer 152 may be, as shown in Fig. 9b, formed under the color filter layer 204.

Meanwhile, as shown in Fig. 10b, in the display panel 200A according to the embodiment of the present invention, a conductive material such as ITO is formed on the spacer 215 located under the first and the third electrode layers 156 and is used as the reference electrode 654.

Here, the first and the third electrode layers 156 may use the common electrode located on the liquid crystal layer 205. Although it has been described that the spacer 215 is provided in the liquid crystal layer 205, the spacer 215 may be formed on the TFT layer 206 including the pixel electrode.

Here, the fringing capacitance C1 to the touch pressure signal may be formed between the reference electrode 654 and the plurality of the first electrodes T using the common electrode. The fringing capacitance C2 may be formed between the reference electrode 654 and the plurality of the third electrodes C using the common electrode.

As shown in Fig. 10b, in the display panel 200A according to the embodiment of the present invention, when a pressure is applied to the touch surface by the touch of the object on the touch surface, the plurality of the first and third electrodes T and C which are composed of the common electrodes move toward the reference electrode 654 and become closer to the reference electrode 654. Accordingly, the mutual capacitance (Cm) is changed (decreased). By the second signal generated as a result of this, the touch pressure can be detected.

Meanwhile, in Figs. 10a and 10b, when the reference electrode 654 is a floating node, the first electrode T and the third electrode C become closer to the reference electrode 654, so that the mutual capacitance (Cm) between the first electrode T and the third electrode C may increase. That is, the capacitance C1 between the reference electrode 654 and the first electrode T and the capacitance C2 between the reference electrode 654 and the third electrode C increase. Besides, the series capacitance of the capacitances C1 and C2, which occupies a certain portion of the mutual capacitance (Cm) of the first electrode T and the third electrode C, also increases. Therefore, the total mutual capacitance (Cm) also increases.

According to the configurations of Figs. 10a and 10b, the embodiment of the present invention can be applied to any drive type liquid crystal display. In other words, the embodiment of the present invention can be applied to a liquid crystal display having a structure in which the common electrode is located on the liquid crystal layer 205 and to liquid crystal display having a structure in which the common electrode is located under the liquid crystal layer 205.

More specifically, the display panel 200A according to the embodiment of Fig. 10a may be applied to a PLS type liquid crystal display or an IPS type liquid crystal display in which the common electrode is located under the liquid crystal layer, and the display panel 200A according to the embodiment of Fig. 10b may be applied to a VA type liquid crystal display or a TN type liquid crystal display in which the common electrode is located on the liquid crystal layer.

For example, the plurality of the common electrodes within the display panel 200A may be arranged at regular intervals in the form of a grid. Here, the common electrodes are grouped, and thus, come to function as the first electrode T and the third electrode C respectively.

The display panel 200A shown in Figs. 10a and 10b is able to function as the display panel 200A by causing the electrical components of the display panel 200A to operate in conformity with their original purpose. Also, the display panel 200A is able to function as a touch pressure sensing module by causing at least some of the electrical components of the display panel 200A to operate for the purpose of detecting the touch pressure and touch position. Here, each of operation modes may be performed in a time-division manner. That is, the display panel 200A may operate as the display module in a first time interval and may function as a touch pressure sensing module and/or touch position sensing (or input) device in a second time interval.

Figs. 9a to 10b have described the embodiment in which all of the components corresponding to the pressure sensors 450 and 460 and the reference potential layer 600 for pressure detection are located within the display panel 200A. Even when such a display panel 200A is used, it is also possible to obtain the effect obtained by using the intermediate device 700 in which a through-hole 740 has been formed.

For example, the display panel 200A described with reference to Figs. 9a to 10b may be disposed in the interior space shown in Fig. 7a formed by the intermediate device 700 and the cover layer 500. Here, there is no need to further include the pressure sensors 450 and 460 and the reference potential layer 600 because the display panel 200A is disposed in the interior space. Alternatively, the display panel 200A which includes, shown in Fig. 7b, the reference potential layer 600 and is shown in Figs. 9a to 10b as well as the intermediate device 700 may form the interior space. Here, there is no need to further include the pressure sensors 450 and 460 in the interior space.

Figs. 9a to 10b show that the electrode for detecting the touch position as well as the electrode for detecting the pressure is included in the display panel 200A. However, according to the embodiment, the electrode for detecting the touch position may be disposed outside the display panel 200A.

Also, Figs. 9a to 10b show that the reference electrode 654 for detecting the pressure is included in the display panel 200A. However, according to the embodiment, the reference electrode 654 may be disposed outside the display panel 200A.

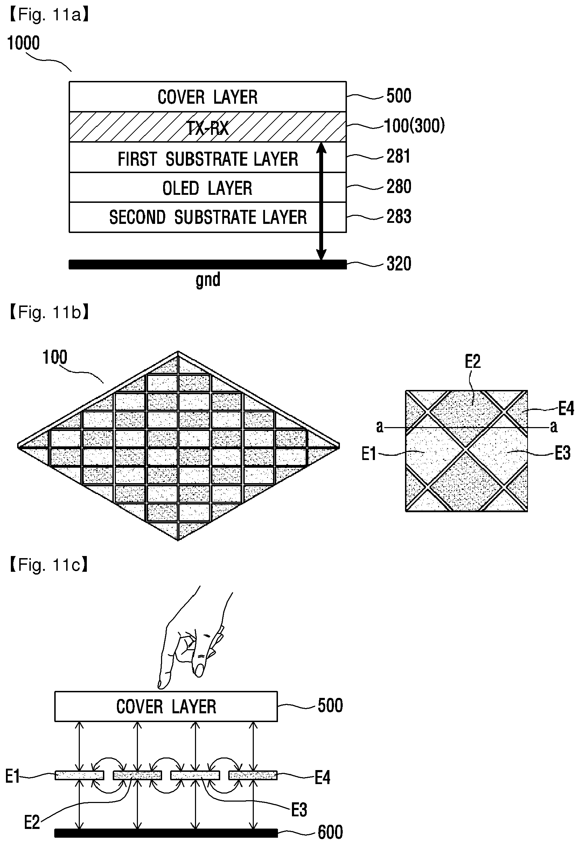

Figs. 11 a to 11 c show a structure of the touch input device including an OLED display panel which does not require an additional pressure sensor. Fig. 11 a shows that the touch sensor 100 is disposed between the first substrate layer 281 and the cover layer 500. In Fig. 11 a, the touch sensor 100 may be formed on the first substrate layer 281. The touch sensor 100 may be used as the pressure sensor. Fig. 11 a shows that the touch sensor 100 and the reference potential layer 600 are disposed apart from each other.

In the embodiment shown in Fig. 11 a, the magnitude of the touch pressure can be detected by the mutual capacitance or self-capacitance which changes according to the distance between the reference potential layer 600 and the touch sensor 100 and is sensed by the touch sensor 100.

Also, in the embodiment shown in Fig. 11 a, the touch position can be detected by the mutual capacitance or self-capacitance which is detected by the touch sensor 100.

Fig. 11 b shows an arrangement of the touch sensor 100 which may be included in the touch input device according to the embodiment shown in Fig. 11 a. The touch sensor 100 may include a plurality of electrodes arranged in the same layer. Here, Fig. 11c shows electrodes E1, E2, E3, and E4 obtained by cutting, as shown on the right side of Fig. 11 b, a portion of the touch sensor 100 along line a-a.

Fig. 11 c is a conceptual view for describing a principle of detecting the touch position and the touch pressure through the arrangement of the touch sensor. As shown in Fig. 11c, the self-capacitance to the reference potential layer 600 is detected from each of the electrodes E1, E2, E3, and E4 included in the touch sensor 100, so that the touch position can be detected. Alternatively, the mutual capacitance generated between the drive electrode E1 and E3 and the receiving electrode E2 and E4, so that the touch position can be detected.

Also, referring to Fig. 11c, at least one of the electrodes included in the touch sensor 100 may be configured to detect the self-capacitance to the reference potential layer 600 and may be used to detect the touch pressure. Alternatively, at least one pair of the drive electrode TX and the receiving electrode RX among the electrodes included in the touch sensor 100 is configured to detect the mutual capacitance between the drive electrode TX and the receiving electrode RX, which changes according to the distance between the reference potential layer 600 and the touch sensor 100, and thus, the at least one pair of the drive electrode TX and the receiving electrode RX may be used to detect the touch pressure.

Figs. 11a to 11c show that the touch sensor 100 is disposed on the first substrate layer 281, i.e., the same single layer. However, the drive electrode TX and the receiving electrode RX of the touch sensor 100 may be disposed in different layers. Alternatively, according to the embodiment, one of the drive electrode TX and the receiving electrode RX may be disposed on the first substrate layer 281 and the other may be disposed under the first substrate layer 281. Alternatively, according to the embodiment, the touch sensor 100 may be formed under the first substrate layer 281 such that the touch sensor 100 is formed in the same single layer or in different layers. Also, the pressure sensors 450 and 460 which are used to detect the pressure may be disposed between the first substrate layer 281 and the OLED layer 280. Here, the pressure sensors 450 and 460 may be an electrode that is used as the touch sensor 100 or may be an electrode that is used to drive the display panel 200A.

Also, the pressure sensors 450 and 460 which are used to detect the pressure in the embodiment may be disposed under the second substrate layer 283. According to the embodiment, the pressure sensors 450 and 460 may be attached to the bottom surface of the second substrate layer 283. According to the embodiment, the pressure sensors 450 and 460 may be separately manufactured and be attached to the second substrate layer 283 or may be formed directly on the second substrate layer 283. For example, the pressure sensors 450 and 460 may be formed directly on the second substrate layer 283 by a patterning method, a printing method, or the like. The patterning method may be performed by using a photoresist, an etching resist, an etching paste, or the like. The printing method may include a gravure printing method, an inkjet printing method, a screen printing method, a flexographic printing method, a transfer printing method, or the like. The description of the formation of the pressure sensors 450 and 460 is not limited to the case where the pressure sensors 450 and 460 are formed under the second substrate layer 283 and may be also applied to a case where the pressure sensors 450 and 460 are formed on a member other than the second substrate layer 283. Although embodiments of the present invention were described above, these are just examples and do not limit the present invention. Further, the present invention may be changed and modified in various ways, without departing from the essential features of the present invention, by those skilled in the art. For example, the components described in detail in the embodiments of the present invention may be modified. Further, differences due to the modification and application should be construed as being included in the scope and spirit of the present invention, which is described in the accompanying claims.

## Claims

1. A touch input device which detects a touch pressure, the touch input device comprising:
a reference potential layer;
a pressure sensor spaced apart from the reference potential layer; and
an intermediate device having at least one through-hole formed therein,
wherein air between the reference potential layer and the pressure sensor flows through the intermediate device via the through-hole,
and wherein a capacitance detected by the pressure sensor is changed according to a change of a distance between the reference potential layer and the pressure sensor.

2. The touch input device of claim 1, wherein the pressure sensor is attached to the intermediate device.

3. The touch input device of claim 1, further comprising a display panel, wherein the pressure sensor is located under the display panel, and wherein the intermediate device is located under the pressure sensor.

4. The touch input device of claim 1, further comprising a display module, wherein the pressure sensor is located under the display module, and wherein the intermediate device is located under the pressure sensor.

5. The touch input device of claim 1, further comprising a display panel, wherein the pressure sensor is included within the display panel.

6. The touch input device of claim 5, wherein the pressure sensor is a common electrode included within the display panel.

7. The touch input device of any one of claims 1 to 6, wherein the pressure sensor comprises at least one pair of a first electrode and a second electrode, and wherein the capacitance is a mutual capacitance between the first electrode and the second electrode.

8. The touch input device of any one of claims 1 to 6, wherein the pressure sensor comprises at least first one electrode, and wherein the capacitance is a self-capacitance of the first electrode with respect to the reference potential layer.

9. A touch input device which detects a touch pressure, the touch input device comprising:
a first electrode;
a second electrode spaced apart from the first electrode; and
an intermediate device having at least one through-hole formed therein,
wherein air between the first electrode and the second electrode flows through the intermediate device via the through-hole,
and wherein a capacitance between the first electrode and the second electrode is changed according to a change of a distance between the first electrode and the second electrode.

10. The touch input device of claim 9, wherein any one of the first electrode and the second electrode is attached to the intermediate device.

11. The touch input device of claim 9, further comprising a display panel, wherein any one of the first electrode and the second electrode is located under the display panel, and wherein the other of the first electrode and the second electrode is attached to the intermediate device.

12. The touch input device of claim 9, further comprising a display panel, wherein any one of the first electrode and the second electrode is included within the display panel.

13. The touch input device of claim 12, wherein any one of the first electrode and the second electrode is a common electrode included within the display panel.

14. The touch input device of any one of claims 9 to 13, wherein at least one of the first electrode and the second electrode comprises a plurality of electrodes forming a plurality of channels.

15. The touch input device of claim 14, wherein the touch input device is configured to detect a plurality of the touch pressures by using the plurality of the channels.
